# EUROPEAN PATENT APPLICATION

(11) **EP 4 206 118 A1**
(43) Date of publication of application: **05.07.2023**
(21) Application number: 21860936.0
(22) Date of filing: 18.06.2021
(51) Int. Cl.: B81B 1/00, B81C 1/00, B01J 19/00

(54) **MICROCHANNEL DEVICE, METHOD FOR PRODUCING OIL DROPLETS, METHOD FOR PRODUCING BUBBLES, METHOD FOR PRODUCING MICROCAPSULES, METHOD FOR PRODUCING MULTIPLE EMULSION, METHOD FOR PRODUCING BUBBLE-ENCAPSULATING DROPLET, AND METHOD FOR PRODUCING MICROCHANNEL DEVICE**

(30) Priority: 25.08.2020 JP 2020141705
(71) Applicant: FUJIFILM Corporation, Tokyo 106-8620 (JP)
(72) Inventor: MATSUNO, Ryo, ashigara-shi, Kanagawa 250-0193 (JP)
(74) Representative: Meissner Bolte Partnerschaft mbB
(86) International application number: PCT/JP2021/023219
(87) International publication number: WO 2022/044505

(57) **Abstract**

The present disclosure provides a microchannel device including a base having a defining surface that defines a flow channel and containing silicone, in which the defining surface of the base includes a region in which a surfactant is adsorbed, and a ratio of an amount of secondary ions of the surfactant adsorbed on the defining surface of the base to a total amount of ions detected by time of flight secondary ion mass spectrometry is 0.01 or more, and provides a use application thereof.

## Description

### BACKGROUND OF THE INVENTION

### 1. Field of the Invention

The present disclosure relates to a microchannel device, a production method for an oil droplet, a production method for an air bubble, a production method for a microcapsule, a production method for a multiple emulsion, a production method for a liquid droplet that encompasses an air bubble, and a manufacturing method for a microchannel device.

### 2. Description of the Related Art

A microchannel device has attracted attention in technical fields such as biological analysis and high-performance materials. The microchannel device is a device including a micro flow channel through which a fluid flows. The fluid is a general term for a liquid and a gas. The flow channel of the microchannel device is utilized, for example, for mixing, separation, analysis, or reaction. The flow channel of the microchannel device is formed by using a nanofabrication technique such as photolithography. For example, the flow channel of the microchannel device is formed through a process of transferring a shape of a mold produced by using a photoresist to silicone rubber. The flow channel of the microchannel device formed by such a method as described above is defined by the surface of the silicone rubber.

The surface of the silicone rubber generally exhibits hydrophobicity. In a microchannel device formed of a hydrophobic material such as silicone rubber, the hydrophobic solid surface that defines a flow channel may adsorb a sample (for example, an enzyme and a protein) that flows through the flow channel. For example, in an analysis using a microchannel device, the adsorption of the sample to the solid surface that defines a flow channel may result in a decrease in the analytical performance and reproducibility of the analysis. For this reason, the solid surface that defines a flow channel is subjected to various hydrophilization treatments.

JP2015-188861A discloses a method of modifying an inner surface of a hydrophobic microchannel. In the modification method disclosed in JP2015-188861A, a solution of a hydrophilic polymer is filled in the microchannel, and then vacuum drying is carried out.

JP2006-292472A discloses an examination chip including a micro flow channel of which the interior wall has been subjected to a blocking treatment. In the blocking treatment disclosed in JP2006-292472A, a blocking agent such as a hydrophilic polymer is used.

### SUMMARY OF THE INVENTION

However, the hydrophilization treatment in the related art cannot impart sufficient hydrophilicity to the solid surface that defines the flow channel of the microchannel device formed of a hydrophobic material. For example, the hydrophilization treatment disclosed in JP2015-188861A or JP2006-292472A may result in a decrease in the uniformity of hydrophilization on the surface to be treated or a decrease in the temporal hydrophilicity. Furthermore, in a microchannel device formed of a hydrophobic material, the low hydrophilicity of the solid surface that defines a flow channel results in an increase in the affinity of the oil phase with respect to the solid surface that defines a flow channel. For example, in a method of producing oil droplets (oil in water; O/W) dispersed in water using a microchannel device, the high affinity of the oil phase with respect to the solid surface that defines a flow channel inhibits the formation of oil droplets in the flow channel. As a result, in the microchannel device formed of a hydrophobic material, the improvement in the hydrophilicity of the solid surface that defines a flow channel is required. In addition, the hydrophilicity of the solid surface that defines a flow channel may affect not only a static behavior of a fluid, which is indicated by an indicator such as a static contact angle but also a dynamic behavior of the fluid that flows through the flow channel. In a case where the hydrophilicity of the solid surface that defines a flow channel is improved, it is also expected, for example, that the maximum processing flow rate for operations such as mixing, separation, and analysis is increased.

An aspect of the present disclosure is to provide a microchannel device including a flow channel that is defined by a solid surface having high hydrophilicity.

Another aspect of the present disclosure is to provide a production method for an oil droplet using a microchannel device including a flow channel that is defined by a solid surface having high hydrophilicity.

Another aspect of the present disclosure is to provide a production method for an air bubble using a microchannel device including a flow channel that is defined by a solid surface having high hydrophilicity.

Another aspect of the present disclosure is to provide a production method for a microcapsule using a microchannel device including a flow channel that is defined by a solid surface having high hydrophilicity.

Another aspect of the present disclosure is to provide a production method for a multiple emulsion using a microchannel device including a flow channel that is defined by a solid surface having high hydrophilicity.

Another aspect of the present disclosure is to provide a production method for a liquid droplet that encompasses an air bubble using a microchannel device including a flow channel that is defined by a solid surface having high hydrophilicity.

Another aspect of the present disclosure is to provide a manufacturing method for a microchannel device including a flow channel that is defined by a solid surface having high hydrophilicity.

The present disclosure includes the following aspects.
<1> A microchannel device comprising a base having a defining surface that defines a flow channel and containing silicone, in which the defining surface of the base includes a region in which a surfactant is adsorbed, and a ratio of an amount of secondary ions of the surfactant adsorbed on the defining surface of the base to a total amount of ions detected by time of flight secondary ion mass spectrometry is 0.01 or more.
<2> The microchannel device according to <1>, in which on the defining surface of the base, a contact angle of water to the region in which the surfactant is adsorbed is 60° or less.
<3> The microchannel device according to <1> or <2>, in which the surfactant adsorbed on the defining surface of the base is an alkylene oxide polymer.
<4> The microchannel device according to <1> or <2>, in which the surfactant adsorbed on the defining surface of the base is an ethylene oxide-propylene oxide copolymer.
<5> The microchannel device according to any one of <1> to <4>, in which the defining surface of the base further includes a region in which the surfactant is not adsorbed.
<6> The microchannel device according to any one of <1> to <5>, further comprising a facing base having a defining surface that defines the flow channel together with the defining surface of the base and coming into contact with the base.
<7> The microchannel device according to <6>, in which the facing base contains silicone.
<8> The microchannel device according to <6>, in which the facing base contains at least one selected from the group consisting of glass and stainless steel.
<9> The microchannel device according to any one of <6> to <8>, in which the defining surface of the facing base includes a region in which the surfactant is adsorbed, and a ratio of an amount of secondary ions of the surfactant adsorbed on the defining surface of the facing base to a total amount of ions detected by time of flight secondary ion mass spectrometry is 0.01 or more.
<10> The microchannel device according to <9>, in which on the defining surface of the facing base, a contact angle of water to the region in which the surfactant is adsorbed is 60° or less.
<11> The microchannel device according to <9> or <10>, in which the surfactant adsorbed on the defining surface of the facing base is an alkylene oxide polymer.
<12>The microchannel device according to <9> or <10>, in which the surfactant adsorbed on the defining surface of the facing base is an ethylene oxide-propylene oxide copolymer.
<13> The microchannel device according to any one of <9> to <12>, in which the defining surface of the facing base further includes a region in which the surfactant is not adsorbed.
<14> The microchannel device according to any one of <1> to <13>, in which the flow channel includes a first flow channel part, a second flow channel part that joins the first flow channel part, and a third flow channel part that is connected to a junction of the first flow channel part with the second flow channel part.
<15> The microchannel device according to any one of <1> to <13>, in which the flow channel includes a first flow channel part, a second flow channel part that joins the first flow channel part, a third flow channel part that is connected to a junction of the first flow channel part with the second flow channel part, a fourth flow channel part that joins the third flow channel part, and a fifth flow channel part that is connected to a junction of the third flow channel part and the fourth flow channel part.
<16> The microchannel device according to any one of <1> to <15>, in which the microchannel device is used for producing an oil droplet.
<17> The microchannel device according to any one of <1> to <15>, in which the microchannel device is used for producing an air bubble.
<18> The microchannel device according to any one of <1> to <15>, in which the microchannel device is used for producing a microcapsule.
<19> The microchannel device according to any one of <1> to <15>, in which the microchannel device is used for producing a multiple emulsion.
<20> The microchannel device according to any one of <1> to <15>, in which the microchannel device is used for producing a liquid droplet that encompasses an air bubble.
<21> A production method for an oil droplet using the microchannel device according to any one of <1> to <15>, the production method for an oil droplet, comprising joining a liquid containing oil and a liquid containing water in the flow channel of the microchannel device to obtain an oil droplet.
<22> A production method for an air bubble using the microchannel device according to any one of <1> to <15>, the production method for an air bubble, comprising joining a liquid and a gas in the flow channel of the microchannel device to obtain an air bubble.
<23> A production method for a microcapsule using the microchannel device according to any one of <1> to <15>, the production method for a microcapsule, comprising joining a liquid containing oil and a liquid containing water in the flow channel of the microchannel device to obtain a microcapsule.
<24> A production method for a multiple emulsion using the microchannel device according to any one of <1> to <15>, the production method for a multiple emulsion, comprising joining at least three liquids in the flow channel of the microchannel device to obtain a multiple emulsion.
<25> A production method for a liquid droplet that encompasses an air bubble using the microchannel device according to any one of <1> to <15>, the production method for a liquid droplet that encompasses an air bubble, comprising joining a gas, a liquid containing oil, and a liquid containing water in the flow channel of the microchannel device to obtain a liquid droplet that encompasses an air bubble.
<26> A manufacturing method for a microchannel device, comprising preparing a first base having a surface that has a groove and containing silicone, subjecting the surface of the first base to a plasma treatment in a presence of a gas containing at least one selected from the group consisting of oxygen, argon, and nitrogen, preparing a second base having a surface for coming into contact with the first base, subjecting the surface of the second base to a plasma treatment in a presence of a gas containing at least one selected from the group consisting of oxygen, argon, and nitrogen, bringing the surface of the second base, subjected to the plasma treatment, into contact with the surface of the first base, subjected to the plasma treatment, to form a flow channel defined by the first base and the second base, while a ratio of an abundance amount of a silica component to an abundance amount of a silicone component, which is measured by X-ray photoelectron spectroscopy on the surface of the first base, is 1.5 or more, causing a composition containing a surfactant to flow into the flow channel, adsorbing the surfactant to a portion of the first base, which comes into contact with the composition, to adjust a ratio of an amount of secondary ions of the surfactant adsorbed to the first base to a total amount of ions detected by time of flight secondary ion mass spectrometry to be 0.01 or more, and adsorbing the surfactant to a portion of the second base, which comes into contact with the composition, to adjust a ratio of an amount of secondary ions of the surfactant adsorbed to the second base to a total amount of ions detected by time of flight secondary ion mass spectrometry to be 0.01 or more.

According to one aspect of the present disclosure, there is provided a microchannel device including a flow channel that is defined by a solid surface having high hydrophilicity.

According to another aspect of the present disclosure, there is provided a production method for an oil droplet using a microchannel device including a flow channel that is defined by a solid surface having high hydrophilicity.

According to another aspect of the present disclosure, there is provided a production method for an air bubble using a microchannel device including a flow channel that is defined by a solid surface having high hydrophilicity.

According to another aspect of the present disclosure, there is provided a production method for a microcapsule using a microchannel device including a flow channel that is defined by a solid surface having high hydrophilicity.

According to another aspect of the present disclosure, there is provided a production method for a multiple emulsion using a microchannel device including a flow channel that is defined by a solid surface having high hydrophilicity.

According to another aspect of the present disclosure, there is provided a production method for a liquid droplet that encompasses an air bubble using a microchannel device including a flow channel that is defined by a solid surface having high hydrophilicity.

According to another aspect of the present disclosure, there is provided a manufacturing method for a microchannel device including a flow channel that is defined by a solid surface having high hydrophilicity.

### BRIEF DESCRIPTION OF THE DRAWINGS

Fig. 1 is a schematic perspective view illustrating a microchannel device according to a certain embodiment of the present disclosure.
Fig. 2 is a schematic cross-sectional view taken along a line II-II illustrated in Fig. 1.
Fig. 3 is a schematic exploded perspective view of the microchannel device illustrated in Fig. 1.
Fig. 4 is a schematic plan view of the microchannel device illustrated in Fig. 1.
Fig. 5 is a schematic plan view illustrating a flow channel of a microchannel device according to a certain embodiment of the present disclosure.
Fig. 6 is a schematic plan view illustrating a flow channel of a microchannel device according to a certain embodiment of the present disclosure.
Fig. 7 is a schematic plan view illustrating a flow aspect of a fluid in a flow channel of a microchannel device according to a certain embodiment of the present disclosure.

### DESCRIPTION OF THE PREFERRED EMBODIMENTS

Hereinafter, embodiments according to the present disclosure will be described in detail. The present disclosure is not limited to the following embodiments. The following embodiments may be appropriately modified within the scope of the object of the present disclosure.

In a case where the embodiments of the present disclosure are described with reference to the drawings, the description of constitutional elements and reference numerals that are overlapped in the drawings may be omitted. The constitutional elements indicated by the same reference numerals in the drawings mean the same constitutional elements. The dimensional ratio in the drawings does not necessarily indicate the actual dimensional ratio.

The numerical range indicated by using "to" in the present disclosure indicates a range including numerical values described before and after "to" as a lower limit value and an upper limit value, respectively. Regarding numerical ranges that are described stepwise in the present disclosure, an upper limit value or a lower limit value described in a numerical value may be replaced with an upper limit value or a lower limit value of another stepwise numerical range. In addition, regarding a numerical range described in the present disclosure, an upper limit value or a lower limit value described in a numerical value may be replaced with a value described in Examples.

In the present disclosure, the amount of each component in a composition means, in a case where the composition contains a plurality of substances corresponding to such a component, the total amount of the plurality of substances in the composition unless otherwise specified.

In the present disclosure, the ordinal numbers (for example, "first" and "second") are terms that are used to distinguish a present of constitutional elements, and thus they do not limit the number of constitutional elements and the superiority or inferiority of the constitutional elements.

In the present disclosure, the term "step" includes not only an independent step but also a step that cannot be clearly distinguished from other steps, as long as the intended purpose of the step is achieved.

In the present disclosure, "% by mass" and "% by weight" are synonymous, and "parts by mass" and "parts by weight" are synonymous.

In the present disclosure, a combination of two or more preferred aspects is a more preferred aspect.

### <Microchannel device>

A microchannel device according to one embodiment of the present disclosure has a base having a defining surface that defines a flow channel and containing silicone. In the above-described embodiment, the defining surface of the base includes a region in which the surfactant is adsorbed. In the above-described embodiment, a ratio of an amount of secondary ions of the surfactant adsorbed on the defining surface of the base to a total amount of ions detected by time of flight secondary ion mass spectrometry (TOF-SIMS) is 0.01 or more. According to the above-described embodiment, there is provided a microchannel device including a flow channel that is defined by a solid surface having high hydrophilicity. In the present disclosure, the above-described base or a material that forms the above-described base may be referred to as a "first base". In the present disclosure, the term "base" refers to the above-described base (that is, the first base) unless otherwise specified.

A presumable reason why the microchannel device exhibiting the above-described effect is provided in one embodiment of the present disclosure will be described below. As described above, the hydrophilization treatment in the related art cannot impart sufficient hydrophilicity to the solid surface that defines the flow channel of the microchannel device formed of a hydrophobic material. In a microchannel device in the related art, which is formed of a hydrophobic material, it is conceived that the hydrophilicity of the solid surface that defines a flow channel is low. On the other hand, in the microchannel device according to one embodiment of the present disclosure, the defining surface of the base includes a region in which a surfactant is adsorbed, and a ratio of an amount of secondary ions of the surfactant adsorbed on the defining surface of the base to a total amount of ions detected by time of flight secondary ion mass spectrometry (TOF-SIMS) is 0.01 or more. The ratio of the amount of secondary ions of the surfactant to the total amount of ions detected by TOF-SIMS indicates an adsorption amount of the surfactant. That is, in a region in which the ratio of the amount of secondary ions of the surfactant to the total amount of ions detected by TOF-SIMS is 0.01 or more, the surfactant having a sufficient amount that contributes to the development of high hydrophilicity is adsorbed. Accordingly, according to one embodiment, there is provided a microchannel device including a flow channel that is defined by a solid surface having high hydrophilicity. Hereinafter, the microchannel device will be specifically described.

### «Base (first base)»

A microchannel device according to one embodiment of the present disclosure has a base having a defining surface that defines a flow channel and containing silicone.

The kind of silicone is not limited. Silicones in the present disclosure include known silicones. Examples of the constitutional unit of the silicone include a dimethyl siloxane unit (-Si(CH₃)₂-O-), a diphenyl siloxane unit (-Si(C₅H₆)₂-O-), and a methylhydrogen siloxane unit (-SiH(CH₃)-O-). The silicone may contain a constitutional unit other than the constitutional unit described above. The silicone may be a homopolymer or a copolymer. Examples of the silicone include polydimethyl siloxane (PDMS), polymethylhydrogen siloxane, and silicone containing a dimethyl siloxane unit and a methylhydrogen siloxane unit. From the viewpoint of transparency and surface characteristics, the silicone is preferably silicone containing at least one selected from the group consisting of a dimethyl siloxane unit, a diphenyl siloxane unit, and a methylhydrogen siloxane unit, and it is more preferably a polydimethyl siloxane. The base may contain two or more kinds of silicones.

The content of the silicone in the base is not limited. From the viewpoint of the transparency of the base and the surface characteristics of the base (for example, hydrophobicity and hydrophilicity improved by surface reforming), the content of the silicone in the base is preferably 85% by mass to 100% by mass, preferably 90% by mass to 100% by mass, and particularly preferably 95% by mass to 100% by mass, with respect to the total mass of the base. The content of the silicone in the base may be less than 100% by mass with respect to the total mass of the base.

The defining surface of the base defines the flow channel of the microchannel device. That is, the defining surface of the base is the surface of the base that faces the flow channel. The number of defining surfaces of the base is not limited. The number of defining surfaces of the base may be one or two or more. The shape of the defining surface of the base is not limited. The defining surface of the base may be, for example, a flat surface or a curved surface.

The defining surface of the base includes a region in which the surfactant is adsorbed. That is, the surfactant is adsorbed to at least a part of the defining surface of the base. The region in which the surfactant is adsorbed improves the hydrophilicity of the solid surface that defines the flow channel. On the defining surface of the base, the position of the region in which the surfactant is adsorbed is not limited. The region on which the surfactant is adsorbed may be disposed on an entirety or a part of the defining surface of the base. The aspect of adsorption is not limited. The adsorption may be, for example, physical adsorption or chemical adsorption. The surfactant adsorbed on the defining surface of the base is detected, for example, by the time of flight secondary ion mass spectrometry described later. The detection of the surfactant adsorbed on the defining surface of the base is carried out after washing the defining surface of the base with a solvent (for example, water, acetone, or ethanol). The kind of the surfactant adsorbed on the defining surface of the base may be one kind or two or more kinds.

The kind of surfactant is not limited. The surfactant in the present disclosure includes known surfactants. Examples of the surfactant include a cationic surfactant, an anionic surfactant, an amphoteric surfactant, and a nonionic surfactant. From the viewpoint of improving hydrophilicity, the surfactant is preferably a nonionic surfactant. From the viewpoint of improving hydrophilicity, the nonionic surfactant is preferably a polymer, more preferably an alkylene oxide polymer, and particularly preferably an ethylene oxide-propylene oxide copolymer. The alkylene oxide polymer is a polymer containing an alkyleneoxy group. The alkylene oxide polymer that is used as a surfactant can be firmly adsorbed on the solid surface that defines a flow channel, and the hydrophilic group of the alkylene oxide polymer adsorbed on the solid surface that defines a flow channel is stably disposed to face the flow channel. As a result, the alkylene oxide polymer that is used as a surfactant can not only improve the hydrophilicity but also suppress, for example, a temporal decrease in hydrophilicity. For example, the hydrophilicity of the solid surface on which the alkylene oxide polymer is adsorbed as a surfactant is unlikely to decrease even in an environment in which the speed of the fluid that flows through the flow channel is high. The alkylene oxide polymer may contain two or more kinds of alkyleneoxy groups. The alkylene oxide polymer may contain an alkyleneoxy group in the main chain, the side chain, or both the main chain and the side chain. The alkylene oxide polymer preferably contains an alkyleneoxy group in the main chain. The alkyleneoxy group may be, for example, a linear alkyleneoxy group or a branched alkyleneoxy group. The alkyleneoxy group is preferably an alkyleneoxy group having 2 to 6 carbon atoms and more preferably an alkyleneoxy group having 2 to 3 carbon atoms. Examples of the alkyleneoxy group include an ethyleneoxy group and a propyleneoxy group. The ethylene oxide-propylene oxide copolymer is a copolymer containing an ethyleneoxy group and a propyleneoxy group. In addition, from the viewpoint of utilization of the microchannel device in technical fields such as biotechnology, food, and cosmetics, the surfactant preferably has high biocompatibility. Examples of the commercially available product of the surfactant include "Pluronic" (product name, BASF SE, for example, F68, F127, and L44) and "Poloxamer" (product name, Merck KGaA, for example, 104 and 188).

The molecular weight of the surfactant is not limited. From the viewpoint of improving hydrophilicity and affinity with respect to a living body, the molecular weight of the surfactant is preferably 2,000 or more, more preferably 5,000 or more, and particularly preferably 10,000 or more. From the viewpoint of the viscosity of the composition containing the surfactant that is used in the manufacturing method for a microchannel device, the molecular weight of the surfactant is preferably 100,000 or less, more preferably 50,000 or less, and particularly preferably 20,000 or less. The molecular weight of the surfactant is preferably 2,000 to 100,000, more preferably 5,000 to 50,000, and particularly preferably 10,000 to 20,000. In the present disclosure, the molecular weight of a surfactant having a molecular weight distribution shall be indicated by a weight-average molecular weight. In the present disclosure, the weight-average molecular weight is measured by gel permeation chromatography (GPC).

The amount of the surfactant adsorbed on the defining surface of the base is indicated by the ratio of the amount of secondary ions of the surfactant to the total amount of ions detected by the time of flight secondary ion mass spectrometry (TOF-SIMS). The ratio of the amount of secondary ions of the surfactant adsorbed on the defining surface of the base to the total amount of ions detected by TOF-SIMS (hereinafter, referred to as "the adsorption amount of the surfactant" in this paragraph) is 0.01 or more. In a case where the adsorption amount of the surfactant is 0.01 or more, the hydrophilicity of the solid surface that defines a flow channel is improved. From the viewpoint of improving hydrophilicity, the adsorption amount of the surfactant is preferably 0.015 or more, more preferably 0.02 or more, and particularly preferably 0.025 or more. The upper limit of the adsorption amount of the surfactant is not limited. The upper limit of the adsorption amount of the surfactant may be, for example, 0.5, 0.3, or 0.1. The adsorption amount of the surfactant is preferably 0.01 to 0.5, more preferably 0.015 to 0.3, and particularly preferably 0.02 to 0.1.

In the present disclosure, the ratio of the amount of secondary ions of the surfactant adsorbed on a target surface to the total amount of ions detected by the time of flight secondary ion mass spectrometry (TOF-SIMS) is measured according to the following method. The relative intensity of a fragment ion (a secondary ion) specific to the surfactant, which is standardized with the intensity of total ions, is calculated by TOF-SIMS that is carried out at n = 2 according to the following conditions. The obtained value is adopted as a ratio of the amount of secondary ions of the surfactant adsorbed on the target surface to the total amount of ions detected by TOF-SIMS. In TOF-SIMS, a known time of flight mass spectrometer is used.
- Primary ion: Bi₃⁺
- Measurement mode: Bunching Mode
- Measurement area: 300 µm (surface resolution: 128 × 128 pixels)
- Number of accumulations: 16 times
- Polarity: Positive

The contact angle of water to the region in which the surfactant is adsorbed on the defining surface of the base (hereinafter, simply referred to as the "contact angle" in this paragraph) is preferably 60° or less, more preferably 50° or less, and particularly preferably 40° or less. The lower limit of the contact angle is not limited. The lower limit of the contact angle may be, for example, 5°, 10°, or 20°. The contact angle is preferably 5° to 60°, more preferably 5° to 50°, and particularly preferably 5° to 40°.

In the present disclosure, the contact angle of water is measured according to the following method. At room temperature of 25°C, 2 µL of pure water is added dropwise onto a target surface that has been made to be horizontal. The contact angle of the liquid droplet one second after the contact of the pure water with the target surface is measured using a contact angle meter (for example, DMs-401, Kyowa Interface Science Co., Ltd.). The obtained value is adopted as the contact angle of water.

The defining surface of the base may further include a region in which the surfactant is not adsorbed. In a certain embodiment, the defining surface of the base includes a region in which the surfactant is adsorbed and a region in which the surfactant is not adsorbed. On the defining surface of the base, the position of the region in which the surfactant is not adsorbed is not limited. The position of the region in which the surfactant is not adsorbed may be determined, for example, according to the kind of fluid. The hydrophilicity of the region in which the surfactant is not adsorbed is low as compared with the hydrophilicity of the region in which the surfactant is adsorbed. In a case of utilizing the relative difference in the hydrophilicity between the region in which the surfactant is adsorbed and the region in which the surfactant is not adsorbed, it is possible to control, for example, flow aspects of a liquid containing oil and a liquid containing water. In a fluid containing a liquid containing oil and a liquid containing water, the liquid containing oil tends to flow in the vicinity of a solid surface having low hydrophilicity. For example, in a case of joining a liquid containing oil and a liquid containing water in a flow channel defined by a solid surface having low hydrophilicity, it is possible to form water droplets. On the other hand, in a fluid containing a liquid containing oil and a liquid containing water, the liquid containing water tends to flow in the vicinity of a solid surface having high hydrophilicity. For example, in a case of joining a liquid containing oil and a liquid containing water in a flow channel defined by a solid surface having high hydrophilicity, it is possible to form oil droplets. In a case of utilizing the above-described phenomenon, it is possible to produce, for example, oil droplets that encompass water, which are dispersed in water. A system containing oil droplets that encompass water, which are dispersed in water, is referred to as a W/O/W type emulsion.

The shape of the base is not limited. From the viewpoint of ease of manufacture, the shape of the base is preferably a flat plate.

The thickness of the base is not limited. The thickness of the base may be determined, for example, in a range of 1 mm to 10 mm. The thickness of the base is preferably in a range of 1 mm to 10 mm, more preferably in a range of 1 mm to 5 mm, and particularly preferably in a range of 1.5 mm to 4 mm.

### <<Facing base (second base)>>

It is preferable that the microchannel device according to one embodiment of the present disclosure further includes a facing base that comes into contact with the base. That is, it is preferable that the microchannel device according to one embodiment of the present disclosure includes the base (that is, the first base) and a facing base that comes into contact with the base. The facing base has a defining surface that defines the flow channel together with the defining surface of the base. The flow channel defined by the defining surface of the facing base is the same as the flow channel defined by the defining surface of the base. That is, the flow channel in the microchannel device including the base and the facing base is formed between the base and the facing base. In the present disclosure, the facing base or a material that forms the facing base may be referred to as a "second base".

A component of the facing base is not limited. Examples of the component of the facing base include silicone, glass, and stainless steel.

In a certain embodiment, the facing base preferably contains silicone. In a case where the facing base contains silicone, the adhesiveness between the facing base and the base is improved. Examples of the silicone include the silicone described in the section of "Base (first base)" described above. The silicone is preferably polydimethyl siloxane. The facing base may contain one kind or two or more kinds of silicones.

The content of the silicone in the facing base is not limited. In a certain embodiment, from the viewpoint of adhesiveness to the base and the surface characteristics of the facing base (for example, ease of surface reforming for improving hydrophilicity), the content of the silicone in the facing base is preferably 85% by mass to 100% by mass, preferably 90% by mass to 100% by mass, and particularly preferably 95% by mass to 100% by mass, with respect to the total mass of the facing base. The content of the silicone in the facing base may be less than 100% by mass with respect to the total mass of the facing base.

In a certain embodiment, the facing base preferably contains at least one selected from the group consisting of glass and stainless steel. The facing base may include, for example, glass, stainless steel, or both glass and stainless steel.

In a certain embodiment, the facing base preferably contains glass. The kind of glass is not limited. The glass in the present disclosure includes known glass. Examples of the component of the glass include Al₂O₃, B₂O₃, CaO, Na₂O, and SiO₂.

In a certain embodiment, the facing base preferably contains stainless steel. The kind of stainless steel is not limited. The stainless steel in the present disclosure includes known stainless steel. Examples of the stainless steel include SUS304 and SUS316. The surface of the facing base containing stainless steel may be subjected to glass-like coating with a silica solgel coating agent.

In the facing base, the content of at least one selected from the group consisting of glass and stainless steel is not limited. In a certain embodiment, from the viewpoint of flatness and hardness, the content of at least one selected from the group consisting of glass and stainless steel in the facing base is preferably 85% by mass to 100% by mass, preferably 90% by mass to 100% by mass, and particularly preferably 95% by mass to 100% by mass, with respect to the total mass of the facing base. The content of at least one selected from the group consisting of glass and stainless steel in the facing base may be less than 100% by mass with respect to the total mass of the facing base.

The content of the glass in the facing base is not limited. In a certain embodiment, from the viewpoint of transparency, the content of the glass in the facing base is preferably 85% by mass to 100% by mass, preferably 90% by mass to 100% by mass, and particularly preferably 95% by mass to 100% by mass, with respect to the total mass of the facing base. The content of the glass in the facing base may be less than 100% by mass with respect to the total mass of the facing base.

The content of the stainless steel in the facing base is not limited. In a certain embodiment, from the viewpoint of flatness and hardness, the content of the stainless steel in the facing base is preferably 85% by mass to 100% by mass, preferably 90% by mass to 100% by mass, and particularly preferably 95% by mass to 100% by mass, with respect to the total mass of the facing base. The content of the stainless steel in the facing base may be less than 100% by mass with respect to the total mass of the facing base.

The defining surface of the facing base defines the flow channel of the microchannel device. That is, the defining surface of the facing base is the surface of the facing base that faces the flow channel. The number of defining surfaces of the facing base is not limited. The number of defining surfaces of the facing base may be one or two or more. The shape of the defining surface of the facing base is not limited. The defining surface of the facing base may be, for example, a flat surface or a curved surface.

From the viewpoint of improving hydrophilicity, it is preferable that the defining surface of the facing base includes a region in which the surfactant is adsorbed. That is, it is preferable that the surfactant is adsorbed to at least a part of the defining surface of the facing base. On the defining surface of the facing base, the position of the region in which the surfactant is adsorbed is not limited. The region on which the surfactant is adsorbed may be disposed on an entirety or a part of the defining surface of the facing base. From the viewpoint of improving hydrophilicity, it is preferable that on the defining surface of the facing base, the region in which the surfactant is adsorbed faces the region in which the surfactant is adsorbed, on the defining surface of the base. This is because, in one compartment of the flow channel, the greater the proportion of the region in which the surfactant is adsorbed in the solid surface that defines the flow channel is, the more the hydrophilicity of the solid surface that defines the flow channel is improved. The aspect of adsorption is not limited. The adsorption may be, for example, physical adsorption or chemical adsorption. The surfactant adsorbed on the defining surface of the facing base is detected, for example, by the time of flight secondary ion mass spectrometry described above. The kind of the surfactant adsorbed on the defining surface of the facing base may be one kind or two or more kinds.

Examples of the surfactant include the surfactant described in the section of "Base (first base)" described above. The preferred kind of the surfactant is the same as the preferred kind of the surfactant described in the section of "Base (first base)" described above. The kind of the surfactant adsorbed on the defining surface of the facing base may be the same as or different from the kind of the surfactant adsorbed on the defining surface of the base. It is preferable that the surfactant adsorbed on the defining surface of the facing base contains the same surfactant as the surfactant adsorbed on the defining surface of the base. The preferred molecular weight of the surfactant is the same as the preferred molecular weight of the surfactant described in the section of "Base (first base)" described above.

The amount of the surfactant adsorbed on the defining surface of the facing base is indicated by the ratio of the amount of secondary ions of the surfactant to the total amount of ions detected by the time of flight secondary ion mass spectrometry (TOF-SIMS). From the viewpoint of improving hydrophilicity, the ratio of the amount of secondary ions of the surfactant adsorbed on the defining surface of the facing base to the total amount of ions detected by TOF-SIMS (hereinafter, referred to as "the adsorption amount of the surfactant" in this paragraph) is preferably 0.01 or more, preferably 0.015 or more, more preferably 0.02 or more, and particularly preferably 0.025 or more. The upper limit of the adsorption amount of the surfactant is not limited. The upper limit of the adsorption amount of the surfactant may be, for example, 0.5, 0.3, or 0.1. The adsorption amount of the surfactant is preferably 0.01 to 0.5, more preferably 0.015 to 0.3, and particularly preferably 0.02 to 0.1.

From the viewpoint of improving hydrophilicity, a contact angle of water to the region in which the surfactant is adsorbed on the defining surface of the facing base (hereinafter, simply referred to as a "contact angle" in this paragraph) is preferably 60° or less, more preferably 50° or less, and particularly preferably 40° or less. The lower limit of the contact angle is not limited. The lower limit of the contact angle may be, for example, 5°, 10°, or 20°. The contact angle is preferably 5° to 60°, more preferably 5° to 50°, and particularly preferably 5° to 40°.

The defining surface of the facing base may further include a region in which the surfactant is not adsorbed. In a certain embodiment, the defining surface of the facing base includes a region in which the surfactant is adsorbed and a region in which the surfactant is not adsorbed. On the defining surface of the facing base, the position of the region in which the surfactant is not adsorbed is not limited. The position of the region in which the surfactant is not adsorbed may be determined, for example, according to the kind of fluid. From the viewpoint of controlling the flow aspect, it is preferable that on the defining surface of the facing base, the region in which the surfactant is not adsorbed faces the region in which the surfactant is not adsorbed, on the defining surface of the base.

The shape of the facing base is not limited. From the viewpoint of ease of manufacture, the shape of the facing base is preferably a flat plate.

The thickness of the facing base is not limited. The thickness of the facing base may be determined, for example, in a range of 1 mm to 20 mm.

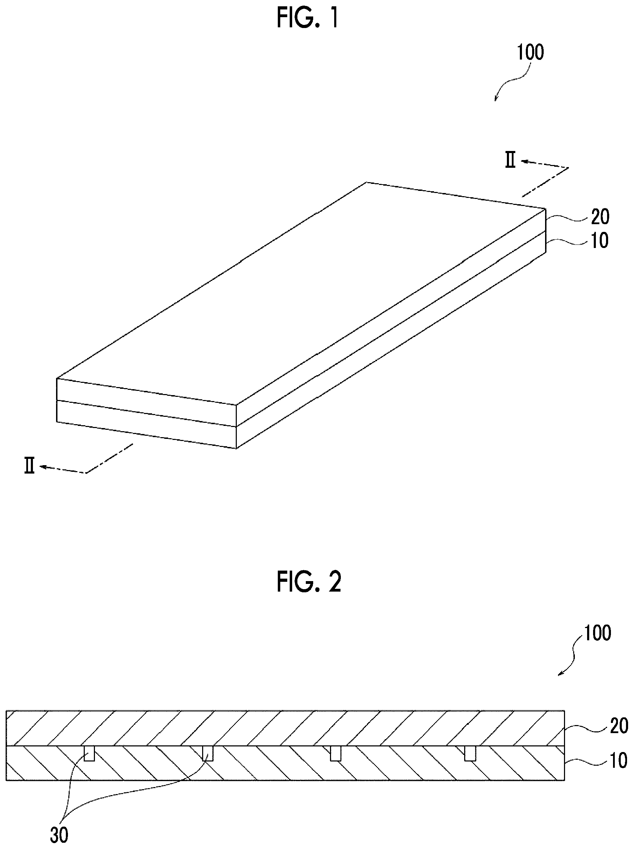

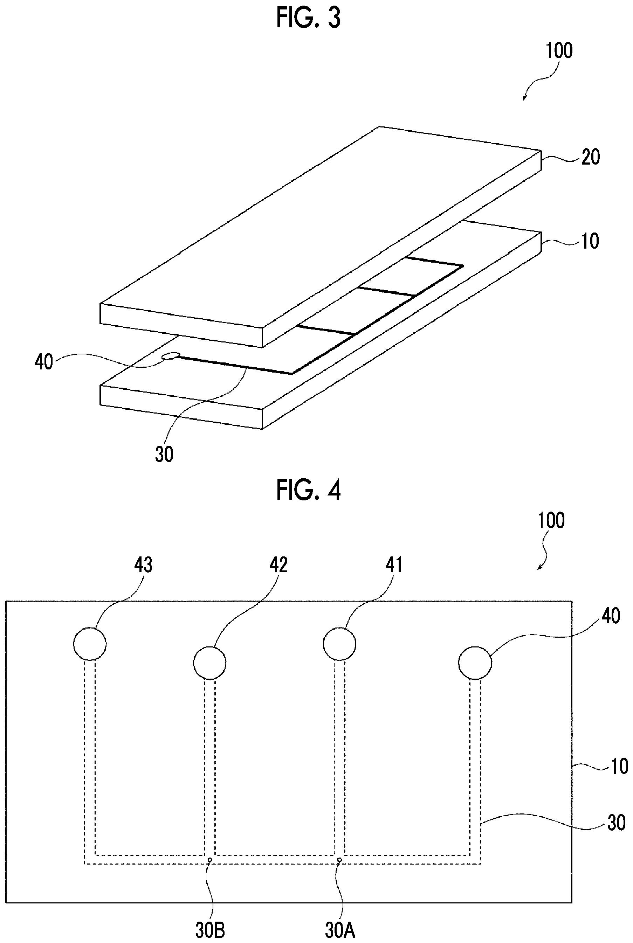

Hereinafter, a microchannel device according to a certain embodiment of the present disclosure will be described with reference to Fig. 1, Fig. 2, Fig. 3, and Fig. 4. Fig. 1 is a schematic perspective view illustrating a microchannel device according to a certain embodiment of the present disclosure. Fig. 2 is a schematic cross-sectional view taken along a line II-II illustrated in Fig. 1. Fig. 3 is a schematic exploded perspective view of the microchannel device illustrated in Fig. 1. Fig. 4 is a schematic plan view of the microchannel device illustrated in Fig. 1.

A microchannel device 100 illustrated in Fig. 1 includes a base (a first base) 10 and a facing base (a second base) 20. The facing base 20 is disposed on the base 10. The facing base 20 is in contact with the base 10.

As illustrated in Fig. 2 and Fig. 3, a flow channel 30 of the microchannel device 100 is formed between the base 10 and the facing base 20. As illustrated in Fig. 2, the flow channel 30 is a space surrounded by a wall surface of a groove (that is, a recessed part) formed on the surface of the base 10 and a surface of the facing base 20. The surface that surrounds the flow channel 30 is the defining surface in the present disclosure. The shape of the flow channel 30 corresponds to the shape of the groove formed on the surface of the base 10. As illustrated in Fig. 4, the flow channel 30 is branched at a junction 30A and a junction 30B.

As illustrated in Fig. 3 and Fig. 4, the microchannel device 100 includes four opening portions that penetrate the base 10. The four opening portions include an opening portion 40, an opening portion 41, an opening portion 42, and an opening portion 43. Each opening portion is connected to the flow channel 30. For example, the three opening portions are used as an introduction part for a fluid, and the remaining one opening portion is used as a discharge part for a fluid. As illustrated in Fig. 4, the shape of each opening portion in a case of being seen in a plan view is a circular shape. However, the shape of the opening portion in a case of being seen in a plan view is not limited to a circular shape. The dimension of each opening portion is determined in consideration of, for example, the dimension of the flow channel (for example, the width of the flow channel).

### «Flow channel»

The flow channel of the microchannel device according to one embodiment of the present disclosure is defined by at least a defining surface of a base. A flow channel of a microchannel device including a base and a facing base is defined by a defining surface of the base and a defining surface of the facing base.

The shape of the flow channel is not limited. Examples of the cross-sectional shape of the flow channel include a quadrangular shape, a circular shape, and a semi-circular shape. For example, a flow channel having a quadrangular shape in a cross section is defined by being surrounded by four plane-shaped defining surfaces. For example, a flow channel having a circular shape in a cross section is defined by being surrounded by one cylinder-shaped defining surface or two curved defining surfaces. For example, a flow channel having a semi-circular shape in a cross section is defined by being surrounded by one curved defining surface and one plane-shaped defining surface. However, the above-described specific example does not limit the relationship between the shape of the flow channel and the aspect of the defining surface (for example, the number and shape of the defining surface).

The width of the flow channel is not limited. The width of the flow channel may be determined, for example, in a range of 1 µm to 2,000 µm. The width of the flow channel is preferably in a range of 5 µm to 1,000 µm, more preferably in a range of 10 µm to 500 µm, and particularly preferably in a range of 20 µm to 400 µm.

The flow channel preferably includes a main flow channel part and at least one branch flow channel part branched from the main flow channel. In the flow channel having the above-described structure, at least two kinds of fluids can be joined at a junction of the main flow channel part with the branch flow channel part. For example, in a case of introducing a first fluid into the main flow channel part and introducing a second fluid into a first branch flow channel part branched from the main flow channel part, it is possible to join the second fluid with respect to the first fluid. For example, in a case of introducing a first fluid into the main flow channel part and introducing a second fluid into a first branch flow channel part branched from the main flow channel part, and in a case of introducing a third fluid into a second branch flow channel part branched from the main flow channel part downstream of a junction of the main flow channel part with the first branch flow channel part, it is possible to sequentially join the second fluid and the third fluid sequentially with respect to the first fluid. The number of branch flow channel parts branched from the main flow channel may be one or two or more. The number of junctions of the main flow channel part with the branch flow channel may be one or two or more. The shape of the junction of the main flow channel part with the branch flow channel is not limited. The shape of the junction of the main flow channel part with the branch flow channel may be determined, for example, according to the number of branch flow channel parts and the joining position of the branch flow channel part with respect to the main flow channel part. Examples of the shape of the junction of the main flow channel part with the branch flow channel include a T shape, a Y shape, and a cross shape.

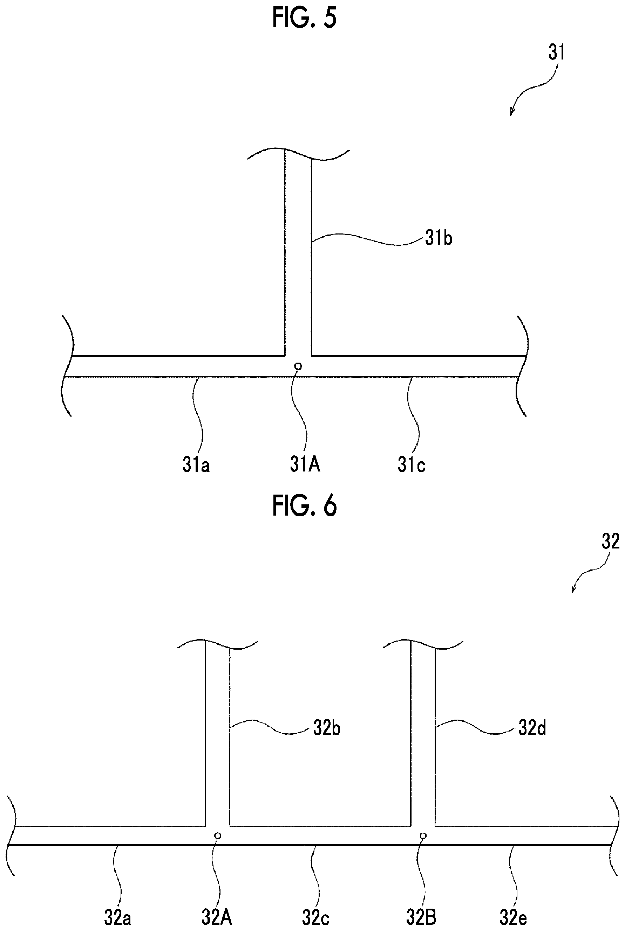

Hereinafter, the configuration of the flow channel will be described with reference to Fig. 5 and Fig. 6. Fig. 5 is a schematic plan view illustrating a flow channel of a microchannel device according to a certain embodiment of the present disclosure. Fig. 6 is a schematic plan view illustrating a flow channel of a microchannel device according to a certain embodiment of the present disclosure. However, the configuration of the flow channel is not limited to the configuration shown below.

In a certain embodiment, it is preferable that the flow channel includes a first flow channel part, a second flow channel part that joins the first flow channel part, and a third flow channel part that is connected to a junction of the first flow channel part with the second flow channel part. In the above-described embodiment, the flow channel may include, for example, four or more flow channel parts and two or more junctions.

In an example of a flow channel including such constitutional elements as described above, a flow channel 31 illustrated in Fig. 5 includes a first flow channel part 31a, a second flow channel part 31b that joins the first flow channel part 31a, and a third flow channel part 31c that is connected to a junction 31A of the first flow channel part 31a with the second flow channel part 31b. The shape of the junction 31A is a T shape.

In the flow channel 31 illustrated in Fig. 5, for example, the first fluid introduced into the first flow channel part 31a joins the second fluid introduced into the second flow channel part 31b at the junction 31A. The first fluid and the second fluid that have been joined at the junction 31A flow through the third flow channel part 31c.

For example, in a method of joining a liquid containing oil and a liquid containing water in the flow channel 31 illustrated in Fig. 5 to produce oil droplets, it is preferable that the solid surface that defines the third flow channel part 31c (preferably, the first flow channel part 31a, the second flow channel part 3 1b, and the third flow channel part 31c) includes a region in which the surfactant is adsorbed. The region in which the surfactant is adsorbed reduces the affinity of the liquid containing oil with respect to the solid surface that defines the flow channel and promotes the formation of oil droplets.

In a certain embodiment, it is preferable that the flow channel includes a first flow channel part, a second flow channel part that joins the first flow channel part, a third flow channel part that is connected to a junction of the first flow channel part with the second flow channel part, a fourth flow channel part that joins the third flow channel part, and a fifth flow channel part that is connected to a junction of the third flow channel part with the fourth flow channel part. In the above-described embodiment, the flow channel may include, for example, six or more flow channel parts and three or more junctions.

In an example of a flow channel including such constitutional elements as described above, a flow channel 32 illustrated in Fig. 6 includes a first flow channel part 32a, a second flow channel part 32b that joins the first flow channel part 32a, a third flow channel part 32c that is connected to a junction 32A of the first flow channel part 32a with the second flow channel part 32b, a fourth flow channel part 32d that joins the third flow channel part 32c, and a fifth flow channel part 32e that is connected to a junction 32B of the third flow channel part 32c with the fourth flow channel part 32d. The shape of the junction 32A is a T shape. The shape of the junction 32B is a T shape.

In the flow channel 32 illustrated in Fig. 6, for example, the first fluid introduced into the first flow channel part 32a joins the second fluid introduced into the second flow channel part 32b at the junction 32A. The first fluid and the second fluid that have been joined at the junction 32A go through the third flow channel part 32c and join the third fluid introduced into the fifth flow channel part 32e at the junction 32B. The first fluid, the second fluid, and the third fluid that have been joined at the junction 32B flow through the fourth flow channel part 32d.

For example, in a method of joining a liquid containing oil as the first fluid, a liquid containing water as the second fluid, and a liquid containing water as the third fluid in the flow channel 32 illustrated in Fig. 6 to produce a W/O/W type emulsion (that is, a system containing oil droplets that encompass water, which are dispersed in water), it is preferable that the solid surface that defines the first flow channel part 32a and the second flow channel part 32b include a region in which the surfactant is not adsorbed. In addition, the solid surface that defines the third flow channel part 32c may include a region in which the surfactant is not adsorbed. The region in which the surfactant is not adsorbed reduces the affinity of the liquid containing water with respect to the solid surface that defines the flow channel and promotes the formation of water droplets. Further, it is preferable that the solid surface that defines the fourth flow channel part 32d and the fifth flow channel part 32e include a region in which the surfactant is adsorbed. The region in which the surfactant is adsorbed reduces the affinity of the liquid containing oil with respect to the solid surface that defines the flow channel and promotes the formation of oil droplets. For example, by utilizing the above-described characteristics, in a case of joining the first fluid (the liquid containing oil) introduced into the first flow channel part 32a, the second fluid (the liquid containing water) introduced into the second flow channel part 32b, and the third fluid (the liquid containing water) introduced into the fifth flow channel part 32e, the water in the second fluid (the liquid containing water) undergoes a process of being covered with the oil in the first fluid (the liquid containing oil) and then the water in the third fluid (the liquid containing water), whereby a W/O/W type emulsion is obtained.

### «Use application»

The use application of the microchannel device according to one embodiment of the present disclosure is not limited. The microchannel device according to one embodiment of the present disclosure may be utilized, for example, for mixing, separation, analysis, or reaction. Specific examples of the use application of the microchannel device according to one embodiment of the present disclosure are shown below. However, the use application of the microchannel device according to one embodiment of the present disclosure is not limited to the specific examples shown below.

### [Production of oil droplet]

The microchannel device according to one embodiment of the present disclosure is preferably used for producing oil droplets. As compared with a microchannel device manufactured by using the hydrophilization treatment in the related art, the solid surface that defines the flow channel of the microchannel device according to one embodiment of the present disclosure can maintain sufficient hydrophilicity, for example, even at a high speed of a fluid that flows through the flow channel due to the action of the surfactant specifically adsorbed on the solid surface that defines the flow channel. It is presumed that such an effect as described above is exhibited since the surfactant such as an alkylene oxide polymer is firmly adsorbed on a solid surface that defines the flow channel and the hydrophilic group of the surfactant is stably disposed to face the flow channel. In addition, such an effect as described above is further enhanced by using an alkylene oxide polymer as the surfactant or by adsorbing the surfactant on a solid surface that has been subjected to a plasma treatment described below. As a result, in a case of using the microchannel device according to one embodiment of the present disclosure, it is possible to improve the productivity of the oil droplets or the stability of the size of the oil droplets as compared with a microchannel device manufactured by using the hydrophilization treatment in the related art.

Examples of the oil droplet include an oil droplet dispersed in water. The oil droplet may encompass, for example, water or air. The oil droplets are produced, for example, by joining a liquid containing oil and a liquid containing water in the flow channel of the microchannel device. The oil droplet may be produced with reference to, for example, a production method for an oil droplet using a known microchannel device. Hereinafter, a production method for an oil droplet using the microchannel device according to one embodiment of the present disclosure will be described.

The production method for an oil droplet according to one embodiment of the present disclosure is a production method for an oil droplet using the microchannel device according to one embodiment of the present disclosure. It is preferable that the production method for an oil droplet according to one embodiment of the present disclosure includes joining a liquid containing oil and a liquid containing water in the flow channel of the microchannel device to obtain the oil droplet.

The oil in the present disclosure includes a liquid that is immiscible with water. Examples of the oil include fluorine oil, octanol, and mineral oil. Examples of the commercially available product of fluorine oil include "NOVEC 7300" (manufactured by 3M Company). The liquid containing oil may contain two or more kinds of oils. The liquid containing oil may contain a component other than oil.

Examples of water include pure water. The liquid containing water may contain a component other than water. It is preferable that the liquid containing water contains, for example, at least one selected from the group consisting of a surfactant and a hydrophilic polymer, which are for improving the formability of oil droplets and the stability of the formed oil droplets. Furthermore, the liquid containing water may contain fine particles or oil droplets, depending on the use application.

Examples of a method of feeding a liquid into the flow channel of the microchannel device include a method using a liquid feeding pump. The kind of liquid feeding pump is not limited. The kind of liquid feeding pump may be determined, for example, according to the kind of the liquid and the amount of the liquid to be fed. Examples of the liquid feeding pump include a syringe pump, a plunger pump, a mono pump, a diaphragm pump, a tubing pump, and a pneumatic pump. From the viewpoint of low pulsation at the time of liquid feeding, a syringe pump, a pneumatic pump, a multiple plunger pump, or a mono pump is preferable.

Examples of a method of joining a liquid containing oil and a liquid containing water include a method of joining a liquid containing oil and a liquid containing water in a flow channel including a main flow channel part and at least one branch flow channel part branched from the main flow channel. In the production method for an oil droplet, for example, a flow channel including constitutional elements as illustrated in Fig. 5 is used. For example, in a case of joining a liquid containing oil and a liquid containing water in the flow channel 31 illustrated in Fig. 5, the liquid containing oil, which flows through the second flow channel part 31b, joins the liquid containing water, which flows through the first flow channel part 31a at the junction 31A, whereby oil droplets are formed.

### [Production of air bubble]

The microchannel device according to one embodiment of the present disclosure is preferably used for producing air bubbles. Examples of the air bubble include air bubbles dispersed in oil and air bubbles dispersed in water. The air bubbles are produced, for example, by joining a liquid and a gas in the flow channel of the microchannel device. The air bubble may be produced with reference to, for example, a production method for an air bubble using a known microchannel device. Hereinafter, a production method for a gas using the microchannel device according to one embodiment of the present disclosure will be described.

The production method for an air bubble according to one embodiment of the present disclosure is a production method for an air bubble using the microchannel device according to one embodiment of the present disclosure. It is preferable that the production method for an air bubble according to one embodiment of the present disclosure includes joining a liquid and a gas in the flow channel of the microchannel device to obtain the air bubble.

Examples of the liquid include a liquid containing oil and a liquid containing water. The oil is as described in the section of "Production of oil droplet" described above. The liquid containing oil may contain two or more kinds of oils. The liquid containing oil may contain a component other than oil. The water is as described in the section of "Production of oil droplet" described above. The liquid containing water may contain a component other than water. The liquid feeding method is as described in the section of "Production of oil droplet" described above.

Examples of the gas include oxygen, nitrogen, a mixture of oxygen and nitrogen, and nitrogen containing a trace amount of a volatile component of fluorine oil.

Examples of a method of joining a liquid and a gas include a method of joining a liquid and a gas in a flow channel including a main flow channel part and at least one branch flow channel part branched from the main flow channel. In the production method for an air bubble, for example, a flow channel including constitutional elements as illustrated in Fig. 5 is used. For example, in a case of joining a liquid and a gas in the flow channel 31 illustrated in Fig. 5, the liquid which flows through the second flow channel part 31b, joins the gas which flows through the first flow channel part 31a at the junction 31A, whereby air bubbles are formed.

### [Production of microcapsule]

The microchannel device according to one embodiment of the present disclosure is preferably used for producing microcapsules. The kind of microcapsule is not limited. The microcapsule may be, for example, a multiple microcapsule. The microcapsule includes, for example, a core material and an outer shell that encompasses the core material.

The kind of core material is not limited. Examples of the substance encompassed by the microcapsule include an organic compound and a solvent. Examples of the organic compound include a flavoring agent, a dye, and a phase change material. Examples of the solvent include water and an organic solvent.

The component of the outer shell of the microcapsule is not limited. Examples of the component of the outer shell of the microcapsule include a polymer. Examples of the polymer include polyurethane, polyurea, polyester, polyether, polyolefin, polyamide, polyvinyl chloride, and an acrylic resin.

The microcapsule is produced, for example, by joining a liquid containing oil and a liquid containing water in the flow channel of the microchannel device. The microcapsule may be produced with reference to, for example, a production method for a microcapsule using a known microchannel device. Hereinafter, a production method for a microcapsule using the microchannel device according to one embodiment of the present disclosure will be described.

The production method for a microcapsule according to one embodiment of the present disclosure is a production method for a microcapsule using the microchannel device according to one embodiment of the present disclosure. It is preferable that the production method for a microcapsule according to one embodiment of the present disclosure includes joining a liquid containing oil and a liquid containing water in the flow channel of the microchannel device to obtain the microcapsule. In a certain embodiment, the microcapsule is preferably formed by a polymerization method. According to the polymerization method, the outer shell of the microcapsule is formed, for example, by a polymerization reaction that proceeds at an interface between a liquid containing oil and a liquid containing water, which have been joined with each other. Examples of the polymerization method include an in situ polymerization method and an interfacial polymerization method. In addition, in a production method for a microcapsule according to another embodiment of the present disclosure, it is also possible to irradiate oil droplets with heat or light in the microchannel device or outside the microchannel device after producing the oil droplets in the flow channel of the microchannel device, thereby polymerizing a polymerizable compound (for example, a monomer) that is contained in the liquid containing oil, the liquid containing water, or both the liquid containing oil and the liquid containing water.

The oil is as described in the section of "Production of oil droplet" described above. The liquid containing oil may contain a component other than oil. The liquid containing oil preferably contains at least one selected from the group consisting of a monomer and a polymerization initiator.

The water is as described in the section of "Production of oil droplet" described above. The liquid containing water may contain a component other than water. The liquid containing water preferably contains at least one selected from the group consisting of a monomer and a polymerization initiator.

The liquid feeding method is as described in the section of "Production of oil droplet" described above.

The method of joining a liquid containing oil and a liquid containing water is as described in the section of "Production of oil droplet" described above. In the production method for a microcapsule, for example, a flow channel including constitutional elements as illustrated in Fig. 5 is used.

In the production method for a multiple microcapsule, the multiple microcapsule is produced, for example, by adjusting the kinds of the liquid to be joined in the flow channel and the joining timing of the liquid according to the configuration of the targeted multiple microcapsule.

### [Production of multiple emulsion]

The microchannel device according to one embodiment of the present disclosure is preferably used for producing a multiple emulsion. Examples of the multiple emulsion include a W/O/W type emulsion. The W/O/W type emulsion is a system containing oil droplets that encompass water, where the oil droplets are dispersed in water. In the multiple emulsion, the number of layers contained in the liquid droplets dispersed in the dispersion medium may be, for example, two layers or three or more layers. The dispersion medium is also referred to as a continuous phase. As will be described later, the microchannel device according to one embodiment of the present disclosure is manufactured through a simple and uniform hydrophilization treatment without undergoing steps such as heating and vacuum drying, which are applied to the hydrophilization treatment of the microchannel device in the related art. As a result, the microchannel device according to one embodiment of the present disclosure can improve, for example, the uniformity of the size of the formed multiple emulsion. Furthermore, for the presumable reason described in the section of "Production of oil droplet" described above, the microchannel device according to one embodiment of the present disclosure can also improve the productivity of the multiple emulsion as compared with a microchannel device produced through the existing hydrophilization treatment.

The multiple emulsion is produced, for example, by joining at least three liquids in the flow channel of the microchannel device. The multiple emulsion may be produced with reference to, for example, a production method for a multiple emulsion using a known microchannel device. Hereinafter, a production method for a multiple emulsion using the microchannel device according to one embodiment of the present disclosure will be described.

The production method for a multiple emulsion according to one embodiment of the present disclosure is a production method for a multiple emulsion using the microchannel device according to one embodiment of the present disclosure. It is preferable that the production method for a multiple emulsion according to one embodiment of the present disclosure includes joining at least three liquids in the flow channel of the microchannel device to obtain the multiple emulsion.

Examples of the liquid include a liquid containing oil and a liquid containing water. The oil is as described in the section of "Production of oil droplet" described above. The liquid containing oil may contain two or more kinds of oils. The liquid containing oil may contain a component other than oil. The water is as described in the section of "Production of oil droplet" described above. The liquid containing water may contain a component other than water. The liquid feeding method is as described in the section of "Production of oil droplet" described above.

Examples of a method of joining at least three liquids include a method of joining at least three liquids in a flow channel including a main flow channel part and at least two branch flow channel parts branched from the main flow channel. The multiple emulsion is produced, for example, by adjusting the kinds of the liquid to be joined in the flow channel and the joining timing of the liquid according to the configuration of the targeted multiple emulsion. In the production method for a multiple emulsion, for example, a flow channel including constitutional elements as illustrated in Fig. 6 is used.

Hereinafter, a production method for a W/O/W type emulsion, which is an example of the multiple emulsion, will be described. In the production method for a W/O/W type emulsion, at least three kinds of liquids include a first liquid containing oil, a second liquid containing water, and a third liquid containing water. The W/O/W type emulsion is obtained, for example, by joining the first liquid containing oil and the second liquid containing water in the flow channel of the microchannel device and then joining the obtained mixture and the third liquid containing water. In the W/O/W type emulsion, the water contained in the second liquid is encompassed in oil droplets dispersed in the dispersion medium. In the W/O/W type emulsion, the oil droplets are formed by the oil contained in the first liquid. In the W/O/W type emulsion, the dispersion medium is formed by the water contained in the third liquid.

### [Production of liquid droplet that encompasses air bubble]

The microchannel device according to one embodiment of the present disclosure is preferably used for producing liquid droplets that encompass air bubbles. Examples of the liquid droplet that encompasses air bubbles include liquid droplets that encompass air bubbles, which are dispersed in a liquid. Examples of the liquid that is used as the dispersion medium include oil and water. Examples of the liquid droplet include an oil droplet and a water droplet. The liquid droplet is preferably an oil droplet. In a case where the liquid droplet is an oil droplet, the liquid that is used as a dispersion medium is preferably water. The liquid droplets that encompass air bubbles are produced, for example, by joining a gas, a liquid containing oil, and a liquid containing water in the flow channel of the microchannel device. The liquid droplet that encompasses air bubbles may be produced with reference to, for example, a production method for an oil droplet using a known microchannel device. Hereinafter, a production method for a liquid droplet that encompasses air bubbles, using the microchannel device according to one embodiment of the present disclosure, will be described.

The production method for a liquid droplet that encompasses air bubbles according to one embodiment of the present disclosure is a production method for a liquid droplet that encompasses air bubbles using the microchannel device according to one embodiment of the present disclosure. It is preferable that the production method for a liquid droplet that encompasses air bubbles according to one embodiment of the present disclosure includes joining a gas, a liquid containing oil, and a liquid containing water in the flow channel of the microchannel device to obtain the liquid droplet that encompasses air bubbles.

The oil is as described in the section of "Production of oil droplet" described above. The liquid containing oil may contain two or more kinds of oils. The liquid containing oil may contain a component other than oil. It is preferable that the liquid containing oil contains, for example, at least one selected from the group consisting of a surfactant and a hydrophobic polymer in order to improve the formability or stability of the water-in-oil droplets. Examples of the preferred surfactant include a glycerin fatty acid ester, a polyoxyethylene ether fatty acid ester, and a perfluoropolyether. Furthermore, the liquid containing oil may contain fine particles or water droplets, depending on the use application.

The water is as described in the section of "Production of oil droplet" described above. The liquid containing water may contain a component other than water. It is noted that in a case where two or more water phases are generated in the liquid droplet that encompasses air bubbles, the liquid containing water preferably contains a salt for adjusting the osmotic pressure in order to suppress the destabilization of the liquid droplet due to the osmotic pressure with the oil phase being sandwiched between at least two water phases.

The liquid feeding method is as described in the section of "Production of oil droplet" described above.

The gas is as described in the section of "Production of oil droplet" described above.

Examples of a method of joining a gas, a liquid containing oil, and a liquid containing water include a method of joining a gas, a liquid containing oil, and a liquid containing water in a flow channel including a main flow channel part and at least two branch flow channel parts branched from the main flow channel. In the production method for a liquid droplet that encompasses air bubbles, for example, a flow channel including constitutional elements as illustrated in Fig. 6 is used.

### [Another use application]

The microchannel device according to one embodiment of the present disclosure may be used for a use application other than the above-described use applications. The microchannel device according to one embodiment of the present disclosure may be used for producing particles having a multilayer structure, such as Janus particles or partial microcapsules in which a part of the multiplexed structure is a solid.

### [Flow aspect]

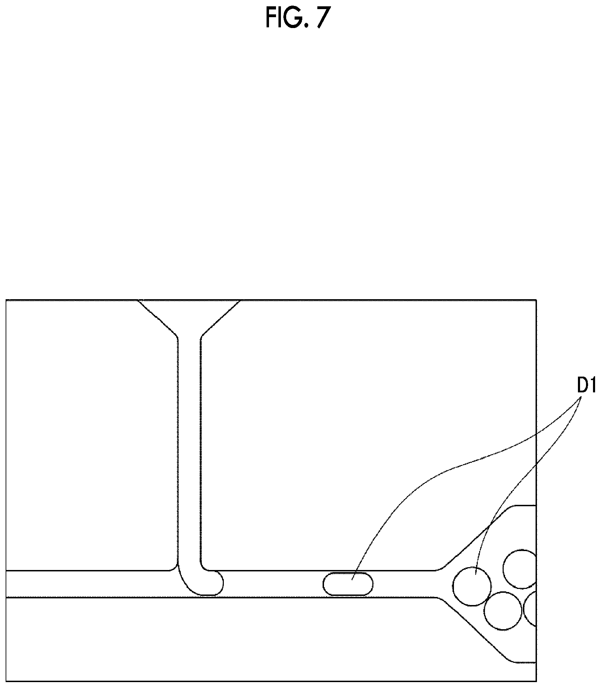

The formation of the liquid droplet will be described with reference to Fig. 7. Fig. 7 is a schematic plan view illustrating a flow aspect of a fluid in a flow channel of a microchannel device according to a certain embodiment of the present disclosure. As illustrated in Fig. 7, a liquid droplet D1 is formed, for example, in a case where two liquids are joined at a T-shaped junction in the flow channel.

### <<Manufacturing method for microchannel device>>

The microchannel device according to one embodiment of the present disclosure is manufactured, for example, by adsorbing a surfactant on a solid surface that defines a flow channel. The adsorption of the surfactant on the solid surface is carried out, for example, by a surface treatment (that is, a hydrophilization treatment) using a composition containing the surfactant. From the viewpoint of improving hydrophilicity, it is preferable that the manufacturing method for a microchannel device includes bringing a composition containing a surfactant into contact with a solid surface hat has been subjected to a plasma treatment, by using a gas containing at least one selected from the group consisting of oxygen, argon, and nitrogen. Furthermore, in a method of manufacturing a microchannel device by contact between a base and a facing base, a plasma treatment using a gas containing at least one selected from the group consisting of oxygen, argon, and nitrogen can improve the adhesiveness between the base and the facing base. In the hydrophilization treatment in which a composition containing a surfactant and a plasma treatment are used in combination, it is possible to simply and uniformly hydrophilize a solid surface of a target without carrying out steps such as heating and vacuum drying, which are applied to the hydrophilization treatment of the microchannel device in the related art. However, the above-described content does not limit the application of the steps such as heating after the hydrophilization treatment and vacuum drying after the hydrophilization treatment. Hereinafter, a preferred manufacturing method for a microchannel device including a base and a facing base will be described as an example of the manufacturing method for a microchannel device.

A manufacturing method for a microchannel device according to one embodiment of the present disclosure preferably includes (1) preparing a first base having a surface that has a groove and containing silicone, (2) subjecting the surface of the first base to a plasma treatment in a presence of a gas containing at least one selected from the group consisting of oxygen, argon, and nitrogen, (3) preparing a second base having a surface for coming into contact with the first base, (4) subjecting the surface of the second base to a plasma treatment in a presence of a gas containing at least one selected from the group consisting of oxygen, argon, and nitrogen, (5) bringing the surface of the second base, subjected to the plasma treatment, into contact with the surface of the first base, subjected to the plasma treatment, to form a flow channel defined by the first base and the second base, while a ratio of an abundance amount of a silica component to an abundance amount of a silicone component, which is measured by X-ray photoelectron spectroscopy on the surface of the first base, is 1.5 or more, (6) causing a composition containing a surfactant to flow into the flow channel, (7) adsorbing the surfactant to a portion of the first base, which comes into contact with the composition, to adjust a ratio of an amount of secondary ions of the surfactant adsorbed to the first base to a total amount of ions detected by time of flight secondary ion mass spectrometry to be 0.01 or more, and (8) adsorbing the surfactant to a portion of the second base, which comes into contact with the composition, to adjust a ratio of an amount of secondary ions of the surfactant adsorbed to the second base to a total amount of ions detected by time of flight secondary ion mass spectrometry to be 0.01 or more. According to the above-described manufacturing method for a microchannel device, a microchannel device including a flow channel that is defined by a solid surface having high hydrophilicity is obtained. Hereinafter, each stage of the manufacturing method for a microchannel device will be specifically described.

### [Step (1)]

In the step (1), a first base having a surface that has a groove and containing silicone is prepared. Hereinafter, a surface that has a groove in the first base may be referred to as a "specific surface of the first base".

Examples of the silicone include the silicone described in the section of "Base (first base)" described above. The silicone is preferably polydimethyl siloxane.

The specific surface of the first base includes a region that comes into contact with the second base in the step (5) described later and a region that defines a flow channel that is formed in the step (5) described later. The specific surface of the first base is subjected to a plasma treatment in the step (2) described later and then is brought into contact with the second base in the step (5) described later. The shape of the groove is not limited. The shape of the groove is determined, for example, according to the shape of the target flow channel. Examples of the cross-sectional shape of the groove include a quadrangular shape and a semi-circular shape. The method of forming the groove is not limited. Examples of the method for forming the groove include a method using a mold produced by photolithography. A large number of flow channels of known microchannel devices are formed, for example, by using a mold produced by photolithography. The first base having a groove is obtained, for example, by bringing a silicone or a composition containing a silicone material into contact with a mold produced by photolithography and then curing the composition. The shape of the protruding part of the mold corresponds to, for example, the shape of the groove (that is, the recessed part) of the first base.

The shape of the first base is not limited. From the viewpoint of ease of manufacture, the shape of the first base is preferably a flat plate. For example, the flat plate-shaped first base has a first main surface and a second main surface on a side opposite to the first main surface. In the flat plate-shaped first base, the specific surface of the first base may be the first main surface or the second main surface.

### [Step (2)]

In the step (2), the specific surface of the first base is subjected to a plasma treatment in the presence of a gas containing at least one selected from the group consisting of oxygen, argon, and nitrogen. In the step (2), a portion that comes into contact with a composition containing a surfactant described later may be also subjected to a plasma treatment, as necessary. In the plasma treatment, for example, a known plasma treatment apparatus may be used.

The gas contains at least one selected from the group consisting of oxygen, argon, and nitrogen. In a certain embodiment, the gas preferably contains oxygen. In a certain embodiment, the gas preferably contains oxygen and argon. In a case of carrying out the plasma treatment in the presence of a gas containing at least oxygen, it is possible to improve the adsorptivity of the surfactant to the defining surface of the first base, and it is possible to improve the adhesiveness between the first base and the second base.

The flow rate of the oxygen in the plasma treatment is preferably 5 sccm to 300 sccm, more preferably 10 sccm to 200 sccm, and particularly preferably 20 sccm to 100 sccm.

The flow rate of the argon in the plasma treatment is preferably 0 sccm to 300 sccm, more preferably 0 sccm to 250 sccm, and particularly preferably 0 sccm to 200 sccm. In a case where the gas that is used for the plasma treatment contains argon, the lower limit of the flow rate of argon is preferably 1 sccm, more preferably 5 sccm, and particularly preferably 20 sccm.

The pressure in the plasma treatment is preferably 10 Pa to 300 Pa, more preferably 15 Pa to 200 Pa, and particularly preferably 20 Pa to 150 Pa.

The treatment time in the plasma treatment is preferably 5 seconds to 120 seconds, more preferably 10 seconds to 100 seconds, and particularly preferably 15 seconds to 80 seconds.

The output in the plasma treatment is preferably 5 W to 300 W, more preferably 10 W to 250 W, and particularly preferably 15 W to 200 W. The output is a radio frequency (RF) output.

### [Step (3)]

In the step (3), a second base having a surface for coming into contact with the first base is prepared. Hereinafter, a surface of the second base, which is for coming into contact with the first base, may be referred to as a "specific surface of the second base".

A component of the second base is not limited. The preferred component of the second base is the same as the preferred component of the facing base, which is described in the section of "Facing base (second base)" described above.

The specific surface of the second base is subjected to a plasma treatment in the step (4) described later and then is brought into contact with the first base in the step (5) described later. A groove may be formed on the specific surface of the second base. The shape of the groove is not limited. The shape of the groove is determined, for example, according to the shape of the target flow channel. Examples of the cross-sectional shape of the groove include a quadrangular shape and a semi-circular shape. Examples of the method for forming the groove include a method using a mold produced by photolithography described in the section of "Step (1)" described above.

The shape of the second base is not limited. From the viewpoint of ease of manufacture, the shape of the second base is preferably a flat plate. For example, the flat plate-shaped second base has a first main surface and a second main surface on a side opposite to the first main surface. In the flat plate-shaped second base, the specific surface of the second base may be the first main surface or the second main surface.

### [Step (4)]

In the step (4), the specific surface of the second base is subjected to a plasma treatment in the presence of a gas containing at least one selected from the group consisting of oxygen, argon, and nitrogen. In the step (4), a portion that comes into contact with a composition containing a surfactant described later may be also subjected to a plasma treatment, as necessary. The preferred conditions for the plasma treatment are the same as the preferred conditions for the plasma treatment described in the section of "Step (2)" described above. It is preferable that the step (4) and the step (2) are carried out at the same time. That is, in the step (2) and the step (4), it is preferable that the specific surface of the first base and the specific surface of the second base are subjected to a plasma treatment at the same time in the presence of a gas containing at least one selected from the group consisting of oxygen, argon, and nitrogen. In a case of carrying out the step (2) and the step (4) at the same time, the time required from the end of the step (2) and the step (4) to the start of the step (5) is shortened, and in the step (5) described later, the adhesiveness between the first base and the second base is improved. The step (2) and the step (4) may be carried out at the same time in, for example, one plasma treatment apparatus.

### [Step (5)]

In the step (5), the specific surface of the second base, subjected to the plasma treatment, is brought into contact with the specific surface of the first base, subjected to the plasma treatment, to form a flow channel defined by the first base and the second base, while a ratio of an abundance amount of a silica component to an abundance amount of a silicone component, which is measured by X-ray photoelectron spectroscopy (XPS) on the specific surface of the first base, is 1.5 or more. After the plasma treatment, the second base is brought into contact with the first base, whereby the second base is adhered to the first base. In the step (5), the groove of the first base is covered with the second base, whereby a space (that is, a flow channel) surrounded by the surface of the first base and the surface of the second base is formed.

In the step (5), in a case of bringing the second base into contact with the first base while a ratio of an abundance amount of a silica component to an abundance amount of a silicone component, which is measured by X-ray photoelectron spectroscopy, is 1.5 or more, the adhesiveness between the first base and the second base is improved. In the step (5), a ratio of an abundance amount of a silica component to an abundance amount of a silicone component, which is measured by X-ray photoelectron spectroscopy, is preferably 2 or more and more preferably 3 or more. The upper limit of the ratio of an abundance amount of a silica component to an abundance amount of a silicone component, which is measured by X-ray photoelectron spectroscopy, is not limited. The ratio of an abundance amount of a silica component to an abundance amount of a silicone component, which is measured by X-ray photoelectron spectroscopy, may be, for example, 6 or less.

Examples of the silicone component include the silicone described in the section of "Base (first base)" described above. Examples of the silica component include a component containing a Si-O bond (for example, SiO₂).

The measurement conditions of the X-ray photoelectron spectroscopy for measuring the ratio of the abundance amount of the silica component to the abundance amount of the silicone component are shown below. A peak of the silica component and a peak of the silicone component, which are detected by X-ray photoelectron spectroscopy, are separated, and then the ratio of the abundance amount (the number of total photoelectrons: c/s (count per second)) of the silica component to the abundance amount of the silicone component (the number of total photoelectrons: c/s (count per second)) is determined.
- X-ray source: Monochromatic Al-Kα ray (100 µmΦ, 25 W, 15 kV)
- Measurement area: 300 µm (Area measurement)
- Pass Energy: 55 eV
- Electrical charge correction: Yes (an electron gun and a low-speed ion gun are used in combination)
- Photoelectron extraction angle: 45 degrees
- Element to be measured: Si2p

In the step (5), after the specific surface of the second base is brought into contact with the specific surface of the first base, a load may be applied to the first base and the second base. In a case of applying a load to the first base and the second base, the adhesiveness between the first base and the second base is improved. The load may be determined, for example, in a range of 50 g/cm² to 500 g/cm². From the viewpoint of improving the adhesiveness between the first base and the second base, it is more preferable that in the step (5), after the specific surface of the second base is brought into contact with the specific surface of the first base under a temperature condition described later, a load is applied to the first base and the second base.

In the step (5), after the specific surface of the second base is brought into contact with the specific surface of the first base, the first base and the second base may be heated. In a case of heating the first base and the second base, the adhesiveness between the first base and the second base is improved. The temperature may be determined, for example, in a range of 100°C to 300°C.

### [Step (6)]

In the step (6), a composition containing a surfactant is caused to flow into the flow channel. Hereinafter, a composition containing a surfactant may be simply referred to as a "composition". The flow channel is a space defined by the first base and the second base. The composition that flows through the flow channel comes into contact with the first base and the second base which define the flow channel.

Examples of the surfactant include the surfactant described in the section of "Base (first base)" described above. The preferred kind of the surfactant is the same as the preferred kind of the surfactant described in the section of "Base (first base)" described above. The composition may contain two or more kinds of surfactants.

The content of the surfactant in the composition is preferably 0.1% by mass to 20% by mass, more preferably 0.5% by mass to 15% by mass, and particularly preferably 2% by mass to 8% by mass, with respect to the total mass of the composition.

The composition containing a surfactant is produced, for example, by mixing a surfactant and a solvent. The solvent is preferably a solvent that does not dissolve the first base and the second base. The solvent is preferably water.

The method of causing the composition to flow into the flow channel is not limited. The composition may be caused to flow into the flow channel by, for example, a method using a liquid feeding pump or an immersion method. The liquid feeding pump is as described in the section of "Production of oil droplet" described above. In the immersion method, the first base and the second base bonded to each other in the step (5) are immersed in a composition, to cause a composition containing a surfactant to flow through the flow channel by a capillary force.

In a method using a liquid feeding means such as a liquid feeding pump, the flow rate of the composition is preferably 0.1 mm/sec to 1,000 mm/sec, more preferably 0.5 mm/sec to 500 mm/sec, and particularly preferably 1 mm/sec to 100 mm/sec. In a case where the flow rate of the composition is 0.1 mm/sec or more, the uniformity of the hydrophilization treatment is improved. In a case where the flow rate of the composition is 1,000 mm/sec or less, the adsorptivity of the surfactant to the first base and the second base is improved.

The flow time of the composition is preferably 0.5 minutes to 120 minutes, more preferably 1 minute to 60 minutes, and particularly preferably 2 minutes to 30 minutes. In the immersion method, the flow time is indicated by the immersion time.

In the step (6), in order to introduce a composition into the flow channel, an opening portion that is connected to the flow channel may be formed in the microchannel device, as necessary. In the step prior to the step (6), the opening portion may be formed in the first base or the second base.

### [Step (7)]

In the step (7), the surfactant is adsorbed to a portion of the first base, which comes into contact with the composition, to adjust a ratio of an amount of secondary ions of the surfactant adsorbed to the first base to a total amount of ions detected by time of flight secondary ion mass spectrometry to be 0.01 or more. Since the composition containing a surfactant, which has flown through the flow channel in the step (6) comes into contact with the surface of the first base that defines the flow channel, the surfactant is adsorbed to the first base. The amount of the surfactant adsorbed to the first base is adjusted, for example, by the content of the surfactant in the composition, the flow rate of the composition, or the flow time of the composition.

### [Step (8)]

In the step (8), the surfactant is adsorbed to a portion of the second base, which comes into contact with the composition, to adjust a ratio of an amount of secondary ions of the surfactant adsorbed to the second base to a total amount of ions detected by time of flight secondary ion mass spectrometry to be 0.01 or more. Since the composition containing a surfactant, which has flown through the flow channel in the step (6) comes into contact with the surface of the second base that defines the flow channel, the surfactant is adsorbed to the second base. The amount of the surfactant adsorbed to the second base is adjusted, for example, by the content of the surfactant in the composition, the flow rate of the composition, or the flow time of the composition.

A microchannel device manufactured through the step (1) to the step (8) described above includes a base having a defining surface that defines a flow channel and containing silicone, and a facing base having a defining surface that defines the flow channel together with the defining surface of the base and coming into contact with the base. In addition, the defining surface of the base includes a region in which the surfactant is adsorbed. The ratio of an amount of secondary ions of the surfactant adsorbed to the defining surface of the base to a total amount of ions detected by time of flight secondary ion mass spectrometry is 0.01 or more. Further, the defining surface of the facing base includes a region in which the surfactant is adsorbed. The ratio of an amount of secondary ions of the surfactant adsorbed to the defining surface of the facing base to a total amount of ions detected by time of flight secondary ion mass spectrometry is 0.01 or more.

### Examples

Hereinafter, the present disclosure will be described in detail according to Examples. However, the present disclosure is not limited to the following Examples. "%" indicates "% by mass" unless otherwise specified.

### <Example 1>

A microchannel device was produced according to the following procedure. The microchannel device includes a base (a first base) and a facing base (a second base) that comes into contact with the base (see, for example, Fig. 1).

### (Step 1: Preparation of photo mask)

A photo mask (System Advance Co., Ltd.) including a blue plate glass and a patterned chromium thin film was prepared. One surface of the blue plate glass (hereinafter, referred to as a "first surface") is covered with a patterned chromium thin film. A region of the first surface of the blue plate glass, which is covered with the patterned chromium thin film, forms a light shielding part of the photo mask. A region of the first surface of the blue plate glass, which is not covered with the patterned chromium thin film, forms a transmissive part of the photo mask. The photo mask includes a T-shaped transmissive part. The line width of the T-shaped transmissive part is 300 µm.

### (Step 2: Production of mold)

A 4-inch silicon wafer (ELECTRONICS AND MATERIALS CORPORATION LIMITED) was washed with acetone and ethanol. The washed silicon wafer was dried at 100°C for 10 minutes using a hot plate (HP-1SA, AS ONE Corporation). The dried silicon wafer was placed on a spin coater (MS-A150, Mikasa Co., Ltd.) by suction. 5 mL of "SU-8 3050" (KAYAKU Advanced Materials, Inc.) was dropwise added onto the silicon wafer. "SU-8 3050" is a negative tone photoresist. After removing air bubbles in the "SU-8 3050" dropwise added onto the silicon wafer, the silicon wafer was rotated at a rotation speed of 1,300 revolutions per minute (rpm) for 30 seconds. The silicon wafer covered with a thin film of "SU-8 3050" was subjected to prebaking at 65°C for 5 minutes and at 95°C for 40 minutes, and then the silicon wafer was cooled to room temperature. The silicon wafer was placed on a mask aligner by suction. A chromium thin film of the photo mask was brought into contact with the thin film of "SU-8 3050", formed on the silicon wafer, and the thin film of "SU-8 3050" was irradiated with ultraviolet rays of 8.0 mW/cm² (wavelength: 365 nm) for 25 seconds. The silicon wafer was subjected to baking at 65°C for 1 minute and then at 95°C for 15 minutes, and then the silicon wafer was cooled to room temperature. The silicon wafer and 10 mL of "SU-8 developer" (KAYAKU Advanced Materials, Inc.) were placed in a glass petri dish having a diameter of 120 mm and then subjected to development for 10 minutes by using a shaker (NR-10, TAITEC CORPORATION). "SU-8 3050" and "SU-8 developer", remaining on the silicon wafer, were washed with isopropyl alcohol (FUJIFILM Wako Pure Chemical Corporation). The silicon wafer was subjected to hard baking at 150°C for 20 minutes by using a hot plate. A mold was obtained according to the above procedure. The mold includes the silicon wafer and a pattern formed on the silicon wafer by using the photoresist.

### (Step 3: Production of first base)

The mold was washed with acetone and ethanol and then dried at 100°C for 10 minutes by using a hot plate. A composition obtained by mixing a main agent of "Sylgard 184" (DuPont Toray Specialty Materials K.K.) and a curing agent at a ratio of 10:1 (in terms of mass ratio) was placed on the mold placed in the glass petri dish. After degassing, the composition was cured by heating at 90°C for 1 hour by using a hot plate. The cured substance was peeled from the mold to obtain a first base containing polydimethyl siloxane (PDMS). A groove is formed on the surface of the first base exposed by the peeling. The shape of the groove formed in the first base corresponds to the shape of the pattern of the mold. The groove depth measured with a laser optical microscope (VK8550, KEYENCE CORPORATION) was in a range of 100 µm to 105 µm. Using a biopsy trephine having a diameter of 1.5 mm (Kai Corporation), three opening portions (that is, holes) were formed in the first base of the microchannel device. Each opening portion is connected to the terminal of a T-shaped flow channel in the step 5 (bonding) described later.

### (Step 4: Plasma treatment)

A plate made of polydimethyl siloxane (PDMS) was prepared as a second base. The first base and the second base were placed in a chamber of a tabletop etcher (14-147, Universal Technics Co., Ltd.). The pressure in the chamber was adjusted to 50 Pa, an argon gas (Ar) 100 sccm of and an oxygen gas (O₂) 20 sccm of were allowed to flow into the chamber, and plasma treatment was carried out for 20 seconds at a radio frequency (RF) output of 20 W. The treatment target surface of the first base is a surface on which the groove is formed. The treatment target surface of the second base is one surface of the second base (that is, the surface of the second base, which comes into contact with the first base in the step 5 described later).

### (Step 5: Bonding)

Immediately after the plasma treatment, the plasma-treated surface of the second base was brought into contact with the plasma-treated surface of the first base (that is, the surface on which the groove of the first base is formed) to bond the first base to the second base. Specifically, the bonding of the first base to the second base was carried out while a ratio of an abundance amount of a silica component to an abundance amount of a silicone component, which is measured by X-ray photoelectron spectroscopy on the plasma-treated surface of the first base, was 1.5 or more. In the microchannel device obtained by bonding the first base to the second base, a T-shaped flow channel as illustrated in Fig. 5 is formed between the first base and the second base. The width of the flow channel is 300 µm.

### (Step 6: Hydrophilization treatment)

APFAtube (outer diameter: 1/16" inch, inner diameter: 0.5 mm) was inserted into each opening portion. PFAis a fluororesin called perfluoroalkoxyalkane. After 1 minute from the end of the plasma treatment, pure water containing 5% by mass of "Pluronic F127" (Merck KGaA) (hereinafter, referred to as a "treatment liquid (1)") was allowed to flow at a flow rate of 3 mL/hour for 5 minutes by using a syringe pump (PHD4400, HARVARD Apparatus). By allowing the treatment liquid (1) to flow into the flow channel, the surface of the first base and the surface of the second base that faces the inside of the flow channel were subjected to the hydrophilization treatment. Finally, the inside of the flow channel of the microchannel device was washed by allowing acetone and ethanol to flow thereinto.

### <Examples 2 to 12>

A microchannel device was produced according to the same procedure as the procedure shown in Example 1, except that the manufacturing conditions were changed according to the description in Table 1.

### <Example 13>

A microchannel device was produced according to the same procedure as the procedure shown in Example 2, except that in the step 6 (the hydrophilization treatment), the hydrophilization treatment was carried out by immersing the microchannel device in the pure water containing 5% by mass of "Pluronic F127" (the treatment liquid (1)) for 10 days.

### <Example 14>

A microchannel device was produced according to the same procedure as the procedure shown in Example 2, except that in the step 6 (the hydrophilization treatment), the hydrophilization treatment was carried out by immersing the microchannel device in the pure water containing 5% by mass of "Pluronic F127" (the treatment liquid (1)) for 60 days.

### <Example 15>

A microchannel device was produced according to the same procedure as the procedure shown in Example 2, except that the plate made of polydimethyl siloxane (PDMS) used as the second base was changed to a blue plate glass.

### <Example 16>

A device was produced in the same manner as in Example 2, except that the plate made of polydimethyl siloxane (PDMS) used as the second base was changed to a plate made of SUS304.

### <Example 17>

A microchannel device was produced according to the same procedure as the procedure shown in Example 1, except that the manufacturing conditions were changed according to the description in Table 1.

### <Comparative Example 1>

A microchannel device was produced according to the same procedure as the procedure shown in Example 1, except that the plasma treatment of the step 4 and the hydrophilization treatment of the step 6 were not carried out.

### <Comparative Example 2>

A microchannel device was produced according to the same procedure as the procedure shown in Example 1, except that the plasma treatment of the step 4 was not carried out.

### <Comparative Example 3>

A microchannel device was produced according to the same procedure as the procedure shown in Example 1, except that in the hydrophilization treatment of the step 6, pure water containing 1% by mass of polyvinyl alcohol (PVA, product name: Poly(vinyl alcohol), Mw: 13,000 to 23,000, 87% to 89%, hydrolyzed, Merck KGaA) was allowed to flow for 10 minutes instead of the treatment liquid (1).

### <Comparative Example 4>

A microchannel device was produced according to the same procedure as the procedure shown in Example 1, except that in the hydrophilization treatment in the step 6, pure water containing 5% by mass of sodium lauryl sulfate (SDS, product name: sodium dodecyl sulfate, FUJIFILM Wako Pure Chemical Corporation) was allowed to flow instead of the treatment liquid (1).

### <Measurement>

### (Contact angle)

Microchannel devices for measuring a contact angle were produced according to the same procedures as the procedures described in corresponding Examples and Comparative Examples, except that the method of the hydrophilization treatment was changed and the width of the flow channel was changed to 5 mm. In the hydrophilization treatment, the microchannel device was immersed in the treatment liquid instead of allowing the treatment liquid for the hydrophilization treatment to flow into the flow channel. The microchannel device for measuring a contact angle was cut using a cutter to expose the surface of the first base that defined the flow channel. The surface of the first base that defined the flow channel was washed with acetone and ethanol and then dried by air blowing. 2 µL of pure water was dropwise added onto the surface of the first base that defined the flow channel. The contact angle of the liquid droplet one second after the contact of the pure water with the surface of the first base that defines the flow channel was measured using DMs-401 manufactured by Kyowa Interface Science Co., Ltd. The contact angle of pure water on the surface of the second base that defined the flow channel was measured according to the same method as described above. The measurement results are shown in Table 1.

### (Adsorption amount)

A microchannel device for measuring an adsorption amount was produced according to the same method as the manufacturing method for a microchannel device for measuring a contact angle. The microchannel device for measuring a contact angle was cut using a cutter to expose the surface of the first base that defined the flow channel. The adsorption amount of the surfactant on the surface of the first base that defined the flow channel was measured by time of flight secondary ion mass spectrometry. Specifically, the relative intensity of a secondary ion (C₃H₇O⁺) of the surfactant, which is standardized with the intensity of total ions, was calculated by TOF-SIMS that was carried out at n = 2 according to the following conditions. The obtained value was adopted as an adsorption amount of the surfactant. The adsorption amount of the surfactant on the surface of the second base that defined the flow channel was measured according to the same method as described above. The measurement results are shown in Table 1.
- Primary ion: Bi₃⁺
- Measurement mode: Bunching Mode
- Measurement area: 300 µm (surface resolution: 128 × 128 pixels)
- Number of accumulations: 16 times
- Polarity: Positive

### (XPS for silica component and silicone component)

The measurement conditions of the X-ray photoelectron spectroscopy (XPS) for measuring the ratio of the abundance amount of the silica component to the abundance amount of the silicone component are shown below. A peak of the silica component and a peak of the silicone component, which were detected by X-ray photoelectron spectroscopy, were separated, and then the ratio of the abundance amount (the number of total photoelectrons: c/s (count per second)) of the silica component to the abundance amount of the silicone component (the number of total photoelectrons: c/s (count per second)) was determined.
- X-ray source: Monochromatic Al-Kα ray (100 µmΦ, 25 W, 15 kV)
- Measurement area: 300 µm (Area measurement)
- Pass Energy: 55 eV
- Electrical charge correction: Yes (an electron gun and a low-speed ion gun are used in combination)
- Photoelectron extraction angle: 45 degrees
- Element to be measured: Si2p

### <Evaluation>

A test of liquid droplet formation was carried out using the produced microchannel device. However, in Comparative Example 1 and Comparative Example 2, the test was carried out in a state where the microchannel device was sandwiched between two glass plates and the microchannel device was pressurized. Hereinafter, a specific procedure of the test will be described with reference to Fig. 5.

Pure water containing 1% by mass of "Pluronic F127" was introduced into the flow channel 31 from an opening portion (not illustrated in the drawing) connected to the first flow channel part 31a, and fluorine oil (NOVEC 7300, 3M company) was introduced into the flow channel 31 from an opening portion connected to the second flow channel part 31b. After joining the pure water containing "Pluronic F127" and the fluorine oil at the junction 31A, the mixture was recovered from an opening portion connected to the third flow channel part 31c. In the method described above, the flow rate of the fluorine oil was changed while maintaining the flow rate of the pure water containing "Pluronic F127" at 25 mL/hour, whereby the range of the flow rate of the fluorine oil, which enables the stable formation of liquid droplets containing the fluorine oil (that is, oil droplets) at the junction between the first flow channel part and the second flow channel part, was determined. Table 1 shows the maximum value (that is, the maximum flow rate of the fluorine oil) in the above-described range. Whether or not the liquid droplets containing the fluorine oil were stably formed was determined based on the flow aspect of the fluorine oil that had passed through the junction 31A and the formation state of the oil droplets. For example, in a case where it was apparently confirmed that a phase containing fluorine oil and a phase containing pure water alternately flow in the flow channel part 31C after the junction 31A and liquid droplets containing fluorine oil are formed, it was determined that the liquid droplets containing fluorine oil were stably formed (see, for example, Fig. 7). However, in a case where the fluorine oil that had passed through the junction 31A did not immediately split into liquid droplets in the flow channel part 31C after the junction 31A, and the length of the continuous phase of the fluorine oil that is present in a region from the junction 31A to the region in which liquid droplets are formed is larger than the length of one liquid droplet to be formed, it was determined that liquid droplets containing fluorine oil were not stably formed.

**[Table 1]**

| | No. | First base (base) | Second base (facing base) | Plasma treatment | | | Hydrophilization treatment | Time required from end of plasma treatment start of hydrophilizationFirst treatment | Measurement | | | | | Evaluation |
|---|---|---|---|---|---|---|---|---|---|---|---|---|---|---|
| | | | | | | Treatment | Component of treatment liquid | | Contact angle [°] to | | Adsorption amount [× 10⁻²] | | Silica component! silicone component | Maximum flow rate of fluorine oil [mL/hour] |
| | | | | Gas kind | RF output | time | (Surfactant and comparative component) | | base | Second base | First base | Second base | | |
| Comparative Example | 1 | PDMS | PDMS | - | - | - | - | - | 110 | 110 | - | - | 0.56 | - |
| Comparative Example | 2 | PDMS | PDMS | - | - | - | F127 5% | - | 107 | 107 | 0.5 | 0.5 | 0.56 | - |
| Comparative Example | 3 | PDMS | PDMS | Ar/O₂ | 20 W | 20 seconds | PVA 1% | 5 minutes | 108 | 108 | - | - | 5 | |
| Comparative Example | 4 | PDMS | PDMS | Ar/O₂ | 20 W | 20 seconds | SDS 5% | 5 minutes | 55 | 55 | - | - | 4.9 | - |
| Example | 1 | PDMS | PDMS | Ar/O₂ | 20 W | 20 seconds | F127 5% | 1 minute | 32 | 32 | 2.6 | 2.6 | 5.1 | 20 |
| Example | 2 | PDMS | PDMS | Ar/O₂ | 20 W | 20 seconds | F127 5% | 5 minutes | 30 | 30 | 2.3 | 2.3 | 5 | 17.5 |
| Example | 3 | PDMS | PDMS | Ar/O₂ | 20 W | 20 seconds | F127 5% | 60 minutes | 33 | 33 | 2 | 2 | 3.8 | 15 |
| Example | 4 | PDMS | PDMS | Ar/O₂ | 20 W | 20 seconds | F127 5% | 4 hours | 34 | 34 | 1.4 | 1.4 | 2.5 | 7 |
| Example | 5 | PDMS | PDMS | N₂/O₂ | 40 W | 20 seconds | F127 5% | 5 minutes | 30 | 30 | 1.2 | 1.2 | 2.2 | 5 |
| Example | 6 | PDMS | PDMS | Ar/O₂ | 20 W | 10 seconds | F127 5% | 5 minutes | 32 | 32 | 6.1 | 6.1 | 5 | 17.5 |
| Example | 7 | PDMS | PDMS | Ar/O₂ | 20 W | 40 seconds | F127 5% | 5 minutes | 30 | 30 | 2.2 | 2.2 | 4.8 | 16 |
| Example | 8 | PDMS | PDMS | Ar/O₂ | 20 W | 80 seconds | F127 5% | 5 minutes | 31 | 31 | 2.4 | 2.4 | 5.1 | 15 |
| Example | 9 | PDMS | PDMS | Ar/O₃ | 40 W | 20 seconds | F127 5% | 5 minutes | 33 | 33 | 2.6 | 2.6 | 5 | 17 |
| Example | 10 | PDMS | PDMS | Ar/O₂ | 80 W | 20 seconds | F127 5% | 5 minutes | 35 | 35 | 4 | 4 | 4.9 | 16 |
| Example | 11 | PDMS | PDMS | Ar/O₂ | 20 W | 20 seconds | F68 5% | 5 minutes | 32 | 32 | 2 | 2 | 5 | 15 |
| Example | 12 | PDMS | PDMS | Ar/O₂ | 20 W | 20 seconds | L44 5% | 5 minutes | 34 | 34 | 2.1 | 2.1 | 4.9 | 12 |
| Example | 13 | PDMS | PDMS | Ar/O₂ | 40 W | 20 seconds | F127 5% | 5 minutes | 29 | 29 | 2.5 | 29 | 5 | 20 |
| Example | 14 | PDMS | PDMS | Ar/O₂ | 40 W | 20 seconds | F127 5% | 5 minutes | 30 | 30 | 2.6 | 30 | 5 | 20 |
| Example | 15 | PDMS | Glass | Ar/O₂ | 20 W | 20 seconds | F127 5% | 5 minutes | 30 | 28 | 2.4 | 2.5 | - | 18 |
| Example | 16 | PDMS | SUS304 | Ar/O₂ | 20 W | 20 seconds | F127 5% | 5 minutes | 30 | 37 | 2.4 | 1.5 | - | 16 |
| Example | 17 | PDMS | PDMS | Ar | 20 W | 20 seconds | F127 5% | 5 minutes | 36 | 36 | 3.5 | 36 | 1.6 | 3 |

In the item "Hydrophilization treatment" described in Table 1, the following abbreviations have the following meanings, respectively.
"F68": Pluronic F68 (Merck KGaA)
"F127": Pluronic F127 (Merck KGaA)
"L44": Pluronic L44 (Merck KGaA)

According to the evaluations shown in Table 1, in Comparative Examples 1 to 4, liquid droplets containing fluorine oil (that is, oil droplets) were not stably formed. On the other hand, in Examples 1 to 17, liquid droplets containing fluorine oil were stably formed. The above results show that in Examples 1 to 17, a microchannel device including a flow channel that is defined by a solid surface having high hydrophilicity is obtained.

### <Example 101>

The first base was bonded to the second base according to the procedure shown in the step 1 to the step 5 of Example 1, thereby obtaining a microchannel device including a flow channel (flow channel width: 100 µm) having such a shape as shown in Fig. 4 was obtained. Using a biopsy trephine having a diameter of 1.5 mm (Kai Corporation), four opening portions (that is, holes) were formed in the first base of the microchannel device. Each opening portion is connected to the terminal of the flow channel (see Fig. 4). After inserting a PFA tube (outer diameter: 1/16" inch, inner diameter: 0.5 mm) into each opening portion, the surface of the first base and the surface of the second base, where each of the surfaces faced the flow channel, were subjected to a hydrophilization treatment. Hereinafter, a specific procedure of the hydrophilization treatment will be described with reference to Fig. 4. Pure water containing 5% by mass of "Pluronic F127" (Merck KGaA) (that is, the treatment liquid (1)) was allowed to flow from the opening portion 41 to the opening portion 40 at a flow rate of 3 mL/hour for 5 minutes, while fluorine oil (NOVEC 7300, 3M company) was allowed to flow from the opening portion 42 to the opening portion 43 at a flow rate of 5 mL/hour for 5 minutes, the surface of the first base and the surface of the second base, where each of the surfaces faced the flow channel connecting the opening portion 41 to the opening portion 40, were subjected to a hydrophilization treatment. On the other hand, since the surface of the first base and the surface of the second base, where each of the surfaces faced the flow channel connecting the opening portion 42 to the opening portion 43, does not come into contact with the treatment liquid (1), they are not subjected to the hydrophilization treatment.

The characteristics of the microchannel device obtained according to the above-described procedure are shown below. The adsorption amount and the contact angle of the surfactant, which are shown below, were measured according to the methods described in the section of "Measurement" described above.
- Adsorption amount of surfactant (first base): 2.4 × 10⁻²
- Adsorption amount of surfactant (second base): 2.4 × 10⁻²
- Contact angle (first base): 31°
- Contact angle (second base): 31°

The microchannel device obtained according to the above-described procedure was used to produce oil droplets (W/O/W) encompassing water, which were dispersed in water. Hereinafter, a specific procedure of the production method for an oil droplet will be described with reference to Fig. 4. Pure water containing 1% by mass of sodium chloride (FUJIFILM Wako Pure Chemical Corporation) and 0.5% by mass of "jeffamine ED2001" (Huntsman Corporation) was introduced from the opening portion 42 into the flow channel 30 at a flow rate of 300 µL/hour, fluorine oil (HFE 7500, 3M Company) containing 10% by mass of "Krytox 157 FSH" (Chemours Company) was introduced from the opening portion 43 into the flow channel 30 at a flow rate of 1.2 mL/hour, and pure water containing 1% by mass of sodium chloride and 1% by mass of "Pluronic F127" was introduced from the opening portion 40 into the flow channel 30 at a flow rate of 1.8 mL/hour. The pure water introduced from the opening portion 42 and the fluorine oil introduced from the opening portion 43 formed water-in-oil droplets at the junction 30B defined by the hydrophobic solid surface. In addition, the water-in-oil droplets formed oil droplets encompassing water, which were dispersed in the water, by being joined with the pure water introduced from the opening portion 40 at the junction 30A defined by the hydrophilic solid surface. The opening portion 41 was used as a recovery part. The obtained oil droplets had an inner diameter of 88.8 µm and an outer diameter of 166 µm, and they were monodisperse liquid droplets.

The disclosure of JP2020-141705 filed on August 25, 2020 is incorporated in the present specification by reference in its entirety. All documents, patent applications, and technical standards described in the present specification are herein incorporated by reference to the same extent that individual documents, patent applications, and technical standards have been specifically and individually indicated to be incorporated by reference, respectively.

### Explanation of References

10: base (first base)
20: facing base (second base)
30, 31, 32: flow channel
31a, 32a: first flow channel part
31b, 32b: second flow channel part
31c, 32c: third flow channel part
32d: fourth flow channel part
32e: fifth flow channel part
30A, 30B, 31A, 32A, 32B: junction
40, 41, 42, 43: opening portion
100: microchannel device
D1: liquid droplet

## Claims

1. A microchannel device comprising:
a base having a defining surface that defines a flow channel and containing silicone,
wherein the defining surface of the base includes a region in which a surfactant is adsorbed, and
a ratio of an amount of secondary ions of the surfactant adsorbed on the defining surface of the base to a total amount of ions detected by time of flight secondary ion mass spectrometry is 0.01 or more.

2. The microchannel device according to claim 1, wherein on the defining surface of the base, a contact angle of water to the region in which the surfactant is adsorbed is 60° or less.

3. The microchannel device according to claim 1 or 2, wherein the surfactant adsorbed on the defining surface of the base is an alkylene oxide polymer.

4. The microchannel device according to claim 1 or 2, wherein the surfactant adsorbed on the defining surface of the base is an ethylene oxide-propylene oxide copolymer.

5. The microchannel device according to any one of claims 1 to 4, wherein the defining surface of the base further includes a region in which the surfactant is not adsorbed.

6. The microchannel device according to any one of claims 1 to 5, further comprising:
a facing base having a defining surface that defines the flow channel together with the defining surface of the base and coming into contact with the base.

7. The microchannel device according to claim 6, wherein the facing base contains silicone.

8. The microchannel device according to claim 6, wherein the facing base contains at least one selected from the group consisting of glass and stainless steel.

9. The microchannel device according to any one of claims 6 to 8,
wherein the defining surface of the facing base includes a region in which the surfactant is adsorbed, and
a ratio of an amount of secondary ions of the surfactant adsorbed on the defining surface of the facing base to a total amount of ions detected by time of flight secondary ion mass spectrometry is 0.01 or more.

10. The microchannel device according to claim 9, wherein on the defining surface of the facing base, a contact angle of water to the region in which the surfactant is adsorbed is 60° or less.

11. The microchannel device according to claim 9 or 10, wherein the surfactant adsorbed on the defining surface of the facing base is an alkylene oxide polymer.

12. The microchannel device according to claim 9 or 10, wherein the surfactant adsorbed on the defining surface of the facing base is an ethylene oxide-propylene oxide copolymer.

13. The microchannel device according to any one of claims 9 to 12, wherein the defining surface of the facing base further includes a region in which the surfactant is not adsorbed.

14. The microchannel device according to any one of claims 1 to 13, wherein the flow channel includes a first flow channel part, a second flow channel part that joins the first flow channel part, and a third flow channel part that is connected to a junction of the first flow channel part with the second flow channel part.

15. The microchannel device according to any one of claims 1 to 13, wherein the flow channel includes a first flow channel part, a second flow channel part that joins the first flow channel part, a third flow channel part that is connected to a junction of the first flow channel part with the second flow channel part, a fourth flow channel part that joins the third flow channel part, and a fifth flow channel part that is connected to a junction of the third flow channel part with the fourth flow channel part.

16. The microchannel device according to any one of claims 1 to 15, wherein the microchannel device is used for producing an oil droplet.

17. The microchannel device according to any one of claims 1 to 15, wherein the microchannel device is used for producing an air bubble.

18. The microchannel device according to any one of claims 1 to 15, wherein the microchannel device is used for producing a microcapsule.

19. The microchannel device according to any one of claims 1 to 15, wherein the microchannel device is used for producing a multiple emulsion.

20. The microchannel device according to any one of claims 1 to 15, wherein the microchannel device is used for producing a liquid droplet that encompasses an air bubble.

21. A production method for an oil droplet using the microchannel device according to any one of claims 1 to 15, the production method for an oil droplet, comprising:
joining a liquid containing oil and a liquid containing water in the flow channel of the microchannel device to obtain an oil droplet.

22. A production method for an air bubble using the microchannel device according to any one of claims 1 to 15, the production method for an air bubble, comprising:
joining a liquid and a gas in the flow channel of the microchannel device to obtain an air bubble.

23. A production method for a microcapsule using the microchannel device according to any one of claims 1 to 15, the production method for a microcapsule, comprising:
joining a liquid containing oil and a liquid containing water in the flow channel of the microchannel device to obtain a microcapsule.

24. A production method for a multiple emulsion using the microchannel device according to any one of claims 1 to 15, the production method for a multiple emulsion, comprising:
joining at least three liquids in the flow channel of the microchannel device to obtain a multiple emulsion.

25. A production method for a liquid droplet that encompasses an air bubble using the microchannel device according to any one of claims 1 to 15, the production method for a liquid droplet that encompasses an air bubble, comprising:
joining a gas, a liquid containing oil, and a liquid containing water in the flow channel of the microchannel device to obtain a liquid droplet that encompasses an air bubble.

26. A manufacturing method for a microchannel device, comprising:
preparing a first base having a surface that has a groove and containing silicone;
subjecting the surface of the first base to a plasma treatment in a presence of a gas containing at least one selected from the group consisting of oxygen, argon, and nitrogen;
preparing a second base having a surface for coming into contact with the first base;
subjecting the surface of the second base to a plasma treatment in a presence of a gas containing at least one selected from the group consisting of oxygen, argon, and nitrogen;
bringing the surface of the second base, subjected to the plasma treatment, into contact with the surface of the first base, subjected to the plasma treatment, to form a flow channel defined by the first base and the second base, while a ratio of an abundance amount of a silica component to an abundance amount of a silicone component, which is measured by X-ray photoelectron spectroscopy on the surface of the first base, is 1.5 or more;
causing a composition containing a surfactant to flow into the flow channel;
adsorbing the surfactant to a portion of the first base, which comes into contact with the composition, to adjust a ratio of an amount of secondary ions of the surfactant adsorbed to the first base to a total amount of ions detected by time of flight secondary ion mass spectrometry to be 0.01 or more; and
adsorbing the surfactant to a portion of the second base, which comes into contact with the composition, to adjust a ratio of an amount of secondary ions of the surfactant adsorbed to the second base to a total amount of ions detected by time of flight secondary ion mass spectrometry to be 0.01 or more.
